# EUROPEAN PATENT SPECIFICATION

(11) **EP 1 941 562 B1**
(45) Date of publication and mention of the grant of the patent: **12.05.2010**
(21) Application number: 06825999.3
(22) Date of filing: 12.10.2006
(51) Int. Cl.: H01L 51/00, H01L 51/50

(54) **ORGANIC ELEMENT FOR LOW VOLTAGE ELECTROLUMINESCENT DEVICES**
ORGANISCHES ELEMENT FÜR ELEKTROLUMINESZENTE NIEDERSPANNUNGS-BAUELEMENTE
ELEMENT ORGANIQUE POUR DISPOSITIFS ELECTROLUMINESCENTS A FAIBLE TENSION

(30) Priority: 26.10.2005 US 259290; 09.08.2006 US 501336
(43) Date of publication of application: 09.07.2008
(73) Proprietor: Global OLED Technology LLC, Wilmington, Delaware 19801 (US)
(72) Inventor: BEGLEY, William, James, Webster, New York 14580 (US); HATWAR, Tukaram, Kisan, Penfield, New York 14526 (US); LIAO, Liang-Sheng, Rochester, New York 14620 (US); SPINDLER, Jeffrey, Paul, Rochester, New York 14617 (US); KLUBEK, Kevin, Paul, West Henrietta, New York 14586 (US)
(74) Representative: Wibbelmann, Jobst
(86) International application number: PCT/US2006/040303
(87) International publication number: WO 2007/050334

(56) References cited:
- WO-A-2004/081017
- WO-A-2006/138075
- US-A1- 2005 019 605
- US-A1- 2005 175 859
- US-A1- 2005 181 232
- HUNG L S ET AL: "Recent progress of molecular organic electroluminescent materials and devices" MATERIALS SCIENCE AND ENGINEERING R: REPORTS, ELSEVIER SEQUOIA S.A., LAUSANNE, CH, vol. 39, no. 5-6, 1 December 2002 (2002-12-01), pages 143-222, XP004391352 ISSN: 0927-796X

## Description

### FIELD OF THE INVENTION

This invention relates to an organic light-emitting diode (OLED) electroluminescent (EL) device having a light-emitting layer and a layer between the light-emitting layer and the cathode containing a cyclometallated complex.

### BACKGROUND OF THE INVENTION

While organic electroluminescent (EL) devices have been known for over two decades, their performance limitations have represented a barrier to many desirable applications. In simplest form, an organic EL device is comprised of an anode for hole injection, a cathode for electron injection, and an organic medium sandwiched between these electrodes to support charge recombination that yields emission of light. These devices are also commonly referred to as organic light-emitting diodes, or OLEDs. Representative of earlier organic EL devices are Gurnee et al. U.S. Pat. No. 3,172,862, issued Mar. 9, 1965; Gurnee U.S. Pat. No. 3,173,050, issued Mar. 9, 1965; Dresner, "Double Injection Electroluminescence in Anthracene", RCA Review, 30, 322, (1969); and Dresner U.S. Pat. No. 3,710,167, issued Jan. 9, 1973. The organic layers in these devices, usually composed of a polycyclic aromatic hydrocarbon, were very thick (much greater than 1 µm). Consequently, operating voltages were very high, often greater than 100V.

More recent organic EL devices include an organic EL element consisting of extremely thin layers (e.g. <1.0 µm) between the anode and the cathode. Herein, the term "organic EL element" encompasses the layers between the anode and cathode. Reducing the thickness lowered the resistance of the organic layers and has enabled devices that operate at much lower voltage. In a basic two-layer EL device structure, described first in US 4,356,429, one organic layer of the EL element adjacent to the anode is specifically chosen to transport holes, and therefore is referred to as the hole-transporting layer, and the other organic layer is specifically chosen to transport electrons and is referred to as the electron-transporting layer. Recombination of the injected holes and electrons within the organic EL element results in efficient electroluminescence.

There have also been proposed three-layer organic EL devices that contain an organic light-emitting layer (LEL) between the hole-transporting layer and electron-transporting layer, such as that disclosed by C. Tang et al. (J. Applied Physics, Vol. 65, 3610 (1989)). The light-emitting layer commonly consists of a host material doped with a guest material, otherwise known as a dopant. Still further, there has been proposed in US 4,769,292 a four-layer EL element comprising a hole injecting layer (HIL), a hole-transporting layer (HTL), a light-emitting layer (LEL) and an electron-transporting/injecting layer (ETL). These structures have resulted in improved device efficiency.

Since these early inventions, further improvements in device materials have resulted in improved performance in attributes such as color, stability, luminance efficiency and manufacturability, e.g., as disclosed in US 5,061,569, US 5,409,783, US 5,554,450, US 5,593,788, US 5,683,823, US 5, 908,581, US 5,928,802, US 6,020,078, and US 6,208,077, amongst others.

Notwithstanding these developments, there are continuing needs for organic EL device components, such as light-emitting materials, sometimes referred to as dopants, that will provide high luminance efficiencies combined with high color purity and long lifetimes. In particular, there is a need to be able to adjust the emission wavelength of the light-emitting material for various applications. For example, in addition to the need for blue, green, and red light-emitting materials there is a need for blue-green, yellow and orange light-emitting materials in order to formulate white-light emitting electroluminescent devices. For example, a device can emit white light by emitting a combination of colors, such as blue-green light and red light or a combination of blue light and yellow light.

The preferred spectrum and precise color of a white EL device will depend on the application for which it is intended. For example, if a particular application requires light that is to be perceived as white without subsequent processing that alters the color perceived by a viewer, it is desirable that the light emitted by the EL device have 1931 Commission International d'Eclairage (CIE) chromaticity coordinates, (CIEx, CIEy), of (0.33, 0.33). For other applications, particularly applications in which the light emitted by the EL device is subjected to further processing that alters its perceived color, it can be satisfactory or even desirable for the light that is emitted by the EL device to be off-white, for example bluish white, greenish white, yellowish white, or reddish white.

White EL devices can be used with color filters in full-color display devices. They can also be used with color filters in other multicolor or functional-color display devices. White EL devices for use in such display devices are easy to manufacture, and they produce reliable white light in each pixel of the displays. Although the OLEDs are referred to as white, they can appear white or off-white, for this application, the CIE coordinates of the light emitted by the OLED are less important than the requirement that the spectral components passed by each of the color filters be present with sufficient intensity in that light. Thus there is a need for new materials that provide high luminance intensity for use in white OLED devices.

A useful class of electron-transporting materials is that derived from metal chelated oxinoid compounds including chelates of oxine itself, also commonly referred to as 8-quinolinol or 8-hydroxyquinoline. Tris(8-quinolinolato)aluminum (III), also known as Alq or Alq₃, and other metal and non-metal oxine chelates are well known in the art as electron-transporting materials.

Tang et al., in US 4,769,292 and VanSlyke et al., in US 4,539,507 lower the drive voltage of the EL devices by teaching the use of Alq as an electron transport material in the luminescent layer or luminescent zone.

Baldo et al., in US 6,097,147 and Hung et al., in US 6,172,459 teach the use of an organic electron-transporting layer adjacent to the cathode so that when electrons are injected from the cathode into the electron-transporting layer, the electrons traverse both the electron-transporting layer and the light-emitting layer.

The use of a mixed layer of a hole-transporting material and an electron-transporting material in the light-emitting layer is well known. For example, see US 2004/0229081; US 6,759,146, US 6,759,146; US 6,753,098; and US 6,713,192 and references cited therein. Kwong and co-workers, US 2002/0074935, describe a mixed layer comprising an organic small molecule hole-transporting material, an organic small molecule electron-transporting material and a phosphorescent dopant.

Tamano et al., in US 6,150,042 teaches use of hole-injecting materials in an organic EL device. Examples of electron-transporting materials useful in the device are given and included therein are mixtures of electron-transporting materials.

Seo et al., in US2002/0086180 teaches the use of a 1:1 mixture of Bphen, (also known as 4,7-diphenyl-1,10-phenanthroline or bathophenanthroline) as an electron-transporting material, and Alq as an electron injection material, to form an electron-transporting mixed layer. However, the Bphen/Alq mix of Seo *et al.,* shows inferior stability.

US 2004/0207318 and U.S 6,396,209 describe an OLED structure including a mixed layer of an electron-transporting organic compound and an organic metal complex compound containing at least one of alkali metal ion, alkali earth metal ion, or rare earth metal ion.

JP 2000053957 teaches the use of photogenes and WO 9963023 the use of organometallic complexes useful in the luminescent layer or the electron injecting/transporting layers but do not teach the use of mixtures of such materials for the electron injecting/transporting layer.

US 2004/0067387 teaches the use of one or more compounds of Formula I, an anthracene structure, in the electron-transporting/electron-injecting layer(s) and one or more compounds not of Formula I including Alq₃ may be added. Alq₃ is not a useful component in the current invention.

US 6,468,676 teaches the use of an organic metal salt, a halogenide, or an organic metal complex for the electron-injection layer. The organic metal complex is at least one selected from a list of metal complexes. There is no indication of mixing a carbocyclic compound.

Zhryuan et al., in Chinese Journal of SemiConductors, Vol. 21, Part 2 (2000), page 184 teaches mixtures of rubrene and phenylpyridine beryllium(BePP₂) as a yellow emitting layer for white OLED. Use of rubrene as a dopant necessitates the rubrene to be present in 2-3 volume %.

Commonly assigned U.S. Serial Nos. 11/076,821; 11/077,218; and 11/116,096 describe mixing a first compound with a second compound that is a low voltage electron transport material, to form a layer on the cathode side of the emitting layer in an OLED device, which gives an OLED device that has a drive voltage even lower than that of the device with the low voltage electron transport material. In some cases a metallic material based on a metal having a work function less than 4.2 eV is included in the layer.

Organometallic complexes, such as lithium quinolate (also known as lithium 8-hydroxyquinolate, lithium 8-quinolate, 8-quinolinolatolithium, or Liq) have been used in EL devices, for example see WO 0032717, US 2005/0151466 and US 2005/0106412. In particular mixtures of lithium quinolate and Alq have been described as useful, for example see US 6,396,209 and US 2004/0207318.

However, these devices do not have all desired EL characteristics in terms of high luminance in combination with low drive voltages. Thus, notwithstanding these developments, there remains a need to reduce drive voltage of OLED devices while maintaining good luminance.

### SUMMARY OF THE INVENTION

One embodiment of the invention provides an OLED device comprising a cathode, a light emitting layer and an anode, in that order, and, having located between the cathode and the light emitting layer, a further layer containing a cyclometallated complex represented by:

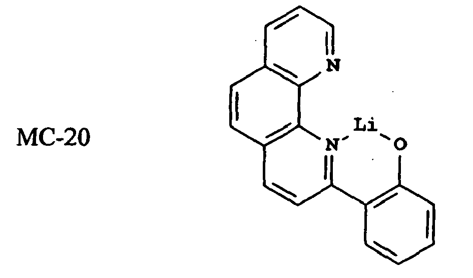

Such a device exhibits reduced drive voltage while maintaining good luminance.

### BRIEF DESCRIPTION OF THE DRAWINGS

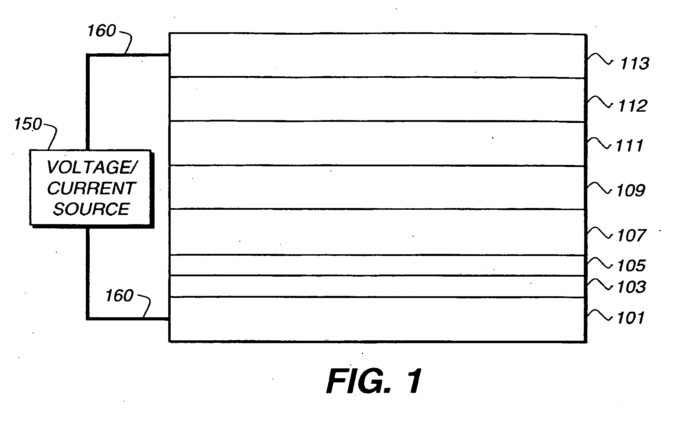

Figure 1 shows a cross-sectional schematic view of one embodiment of the device of the present invention.
Figures 2 and 3 are graphs that show Operating Lifetime Data for devices of the invention.

### DETAILED DESCRIPTION OF THE INVENTION

The OLED devices in all aspects of this invention include a cathode, a light emitting layer and an anode in that order. As used herein two layers are "adjacent" if one layer is juxtaposed with and shares a common boundary with the other layer.

In a first aspect of the invention, the OLED device has located between the cathode and the light-emitting layer, a further layer that contains a single cyclometallated complex represented by:

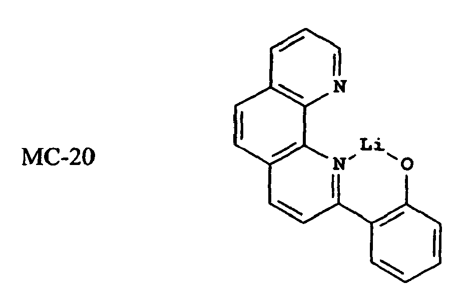

In a second aspect of the invention, also the light-emitting layer can comprise up to 10 volume % of a light emitting compound with at least one anthracene host compound of formula (I)

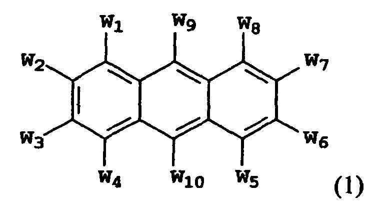

In Formula (I), W₁-W₁₀ independently represent hydrogen or an independently selected substituent. In one embodiment of the invention W₁-W₁₀ are independently selected from hydrogen, alkyl, aromatic carbocyclic and aromatic heterocyclic groups. In another embodiment of the invention, W₉ and W₁₀ represent independently selected aromatic carbocyclic and aromatic heterocyclic groups. In yet another embodiment of the invention W₉ and W₁₀ are independently selected from phenyl, naphthyl and biphenyl groups. For example, W₉ and W₁₀ may represent such groups as 1-naphthyl, 2-naphthyl, 4-biphenyl, 2-biphenyl and 3-biphenyl. In a desirable embodiment, at least one of W₉ and W₁₀ represents a carbocyclic group selected from an anthracenyl group (derived from anthracene). Particularly useful anthracene derived groups are 9-anthracenyl groups. In a further aspect of the invention, W₁ - W₈ represent hydrogen, alkyl or phenyl groups. Particularly useful embodiments of the invention are when W₉ and W₁₀ are aromatic carbocyclic groups and W₇ and W₃ are independently selected from hydrogen, alkyl and phenyl groups.

OLED devices with MC-20 in the layer between the cathode and the light-emitting layer, and up to 10-volume % of at least one anthracene host compound of Formula (1) in the light emitting layer are particularly useful devices of this aspect of the invention. Particularly useful anthracene host compounds of Formula (1) for the light-emitting layer are found in examples Cpd-8, Cpd-9, Cpd-10, Cpd-12 and Cpd-13.

For the purpose of the different aspects of this invention, the terms complex, organic complex and cyclometallated complex describe the complexation of lithium with an organic molecule via coordinate or dative bonding. The molecule, acting as a ligand, can be mono-, di-, tri- or multi-dentate in nature, indicating the number of potential coordinating atoms in the ligand. It should be understood that the number of ligands surrounding a metal ion should be sufficient to render the complex electrically neutral. In addition, it should be understood that a complex can exist in different crystalline forms in which there can be more than one metal ion present from form to form, with sufficient ligands present to impart electrical neutrality.

The definition of a coordinate or dative bond can be found in *Grant & Hackh's Chemical Dictionary,* page 91. In essence, a coordinate or dative bond is formed when electron rich atoms such as O or N, donate a pair of electrons to electron deficient atoms such as Al or B. One such example is found in tris(8-quinolinolato)aluminum(III), also referred to as Alq, wherein the nitrogen on the quinoline moiety donates its lone pair of electrons to the aluminum atom thus forming a heterocyclic or cyclometallated ring, called a complex and hence providing Alq with a total of 3 fused rings. The same applies to Liq.

As used herein and throughout this application, the term carbocyclic and heterocyclic rings or groups are generally as defined by the Grant & Hackh's Chemical Dictionary, Fifth Edition, McGraw-Hill Book Company. A carbocyclic ring is any aromatic or non-aromatic ring system containing only carbon atoms and a heterocyclic ring is any aromatic or non-aromatic ring system containing both carbon and non-carbon atoms such as nitrogen (N), oxygen (O), sulfur (S), phosphorous (P), silicon (Si), gallium (Ga), boron (B), beryllium (Be), indium (In), aluminum (Al), and other elements found in the periodic table useful in forming ring systems. Also, for the purpose of the aspects of this invention, also included in the definition of a heterocyclic ring are those rings that include coordinate or dative bonds.

In a third aspect of the invention the device of the first aspect or second aspect also contains an additional layer located between the anode and the light-emitting layer and the additional layer contains a compound of Formula (2).

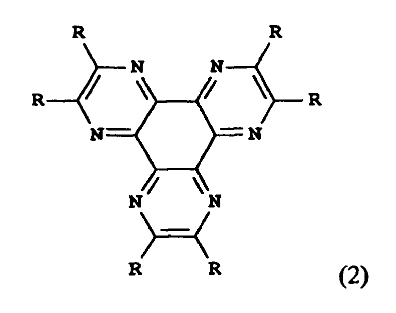

In Formula (2), R independently represents hydrogen or an independently selected substituent, at least one R represents an electron-withdrawing substituent having a Hammett's sigma para value of at least 0.3.

For an explanation of Hammett sigma values and a listing of the values for various substituents see C. Hansch, A. Leo, D. Hoekman; Exploring QSAR: Hydrophobic, Electronic, and Steric Constants. American Chemical Society: Washington, DC 1995*.* Also, C. Hansch, A. Leo; Exploring QSAR: Fundamentals and Applications in Chemistry and Biology. American Chemical Society: Washington, DC 1995*.*

In one embodiment of the third aspect of the invention, each R of Formula (2) is independently selected from the group consisting of hydrogen, C₁ to C₁₂ hydrocarbon, halogen, alkoxy, arylamine, ester, amide, aromatic carbocyclic, aromatic heterocyclic, nitro, nitrile, sulfonyl, sulfoxide, sulfonamide, sulfonate, and trifluoromethyl groups. Particularly useful R groups are independently selected from the group consisting of nitrile, nitro, ester, and amide. Additional useful embodiments of this aspect of the invention are realized when the additional layer is located adjacent to a hole-transporting layer. Specific compounds for use in the additional layer are as follows:

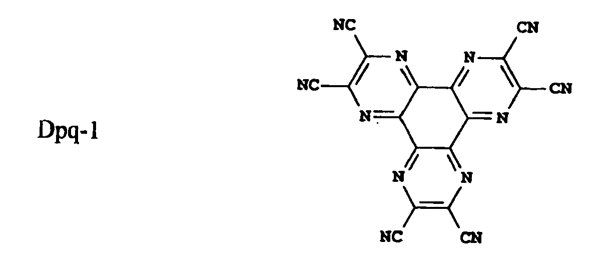

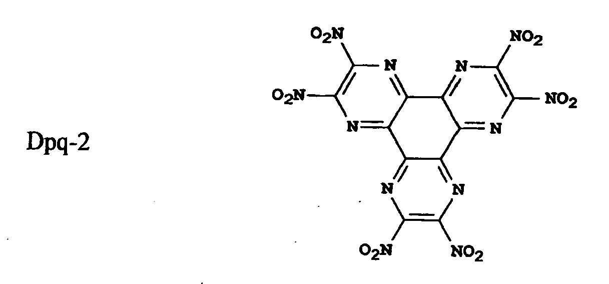

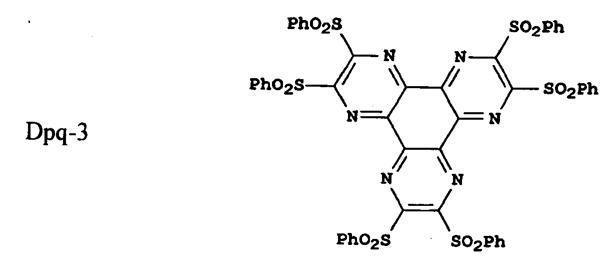

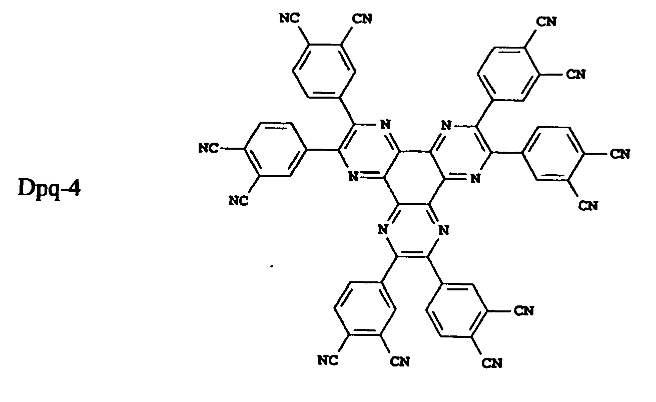

The architecture of the OLED devices of all aspects of the invention can be constructed, by the careful selection of hosts and dopants (also known as light emitting materials), so that the devices can be made to emit blue, green, red or white light. Additionally, in all of the aforementioned aspects, the layer or further layer of the invention may be light-emitting, in which case the device includes two light-emitting layers, for example such as in an EL device that produces white light. In another embodiment the layer or further layer does not emit light. By this it is meant that the layer does not emit substantial amounts of light. Suitably, this layer emits less than 5%, or even less than 1% of the light and desirably it emits no light at all.

In one embodiment of all aspects of the invention, the layer or further layer is located adjacent to the cathode and functions as an electron-transporting layer. In another embodiment of all aspects of the invention, the layer or further layer is located adjacent to an electron-injecting layer, which is adjacent to the cathode. Electron-injecting layers include those taught in US 5,608,287; 5, 776,622; 5,776,623; 6,137,223; and 6,140,763. An electron-injecting layer generally consists of an electron-injecting material having a work function less than 4.2 eV or the salt of a metal having a work function less than 4.2 eV. A thin-film containing low work-function alkaline metals or alkaline earth metals, such as Li, Na, K, Rb,Cs, Ca, Mg, Sr and Ba can be employed. In addition, an organic material doped with these low work- function metals can also be used effectively as the electron-injecting layer. Examples are Li- or Cs-doped Alq. In one suitable embodiment, the electron-injecting layer includes alkali and alkaline earth metal inorganic salts, including their oxides. Also included are alkali and alkaline earth metal organic salts and complexes. In fact, any metal salt or compound which can be reduced in the device to liberate its free metal, either as a free entity or a transient species, are useful in the electron-injecting layer. Examples include, lithium fluoride (LiF), sodium fluoride (NaF), cesium fluoride (CsF), lithium oxide (Li₂O), lithium acetylacetonate (Liacac), lithium benzoate, potassium benzoate, lithium acetate and lithium formate. In practice, the electron-injecting layer is often a thin interfacial layer deposited to a suitable thickness in a range of 0.1-10.0 nm, but more typically in the range of 0.1-5.0 nm. An interfacial electron-injecting layer in this thickness range will provide effective electron injection into the layer or further layer of the invention. Optionally, the electron injecting layer may be omitted from the invention.

Examples of useful anthracene hosts of formula (I) for the light-emitting layer are as follows:

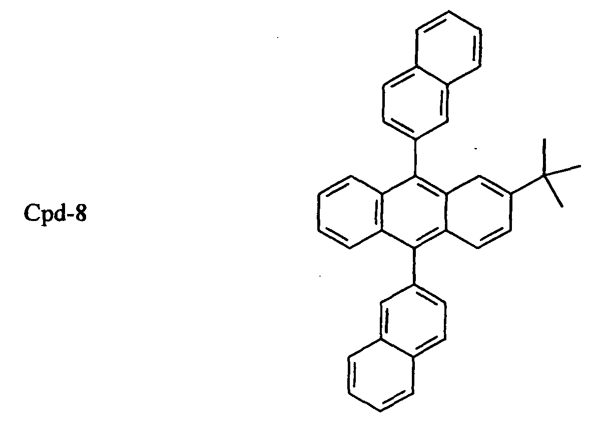

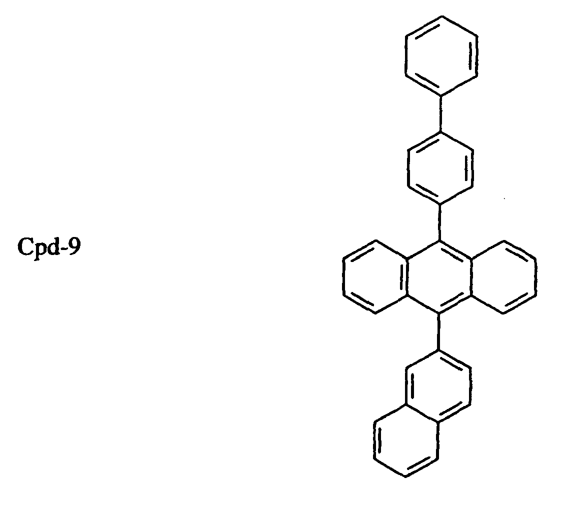

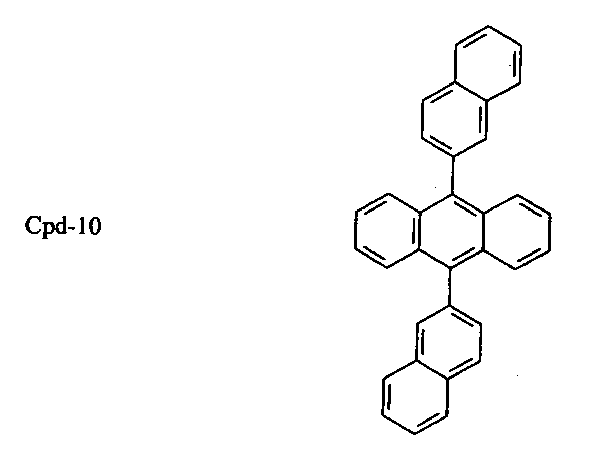

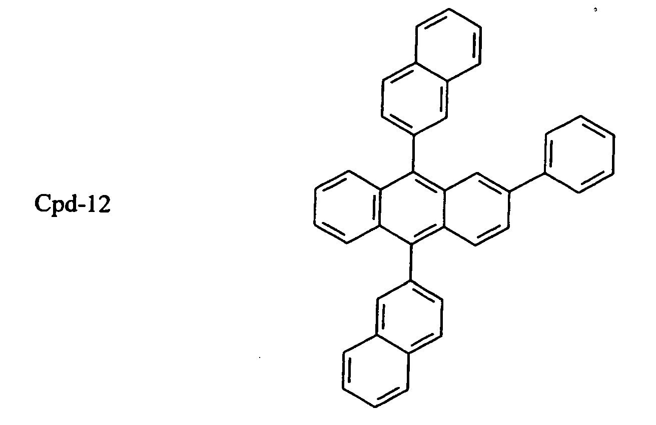

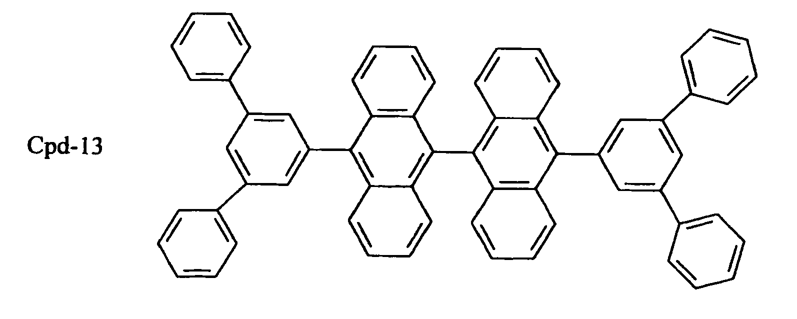

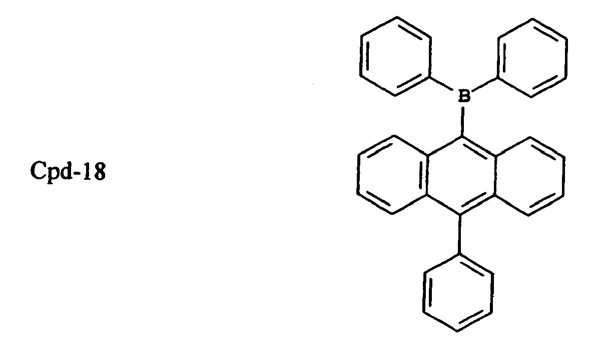

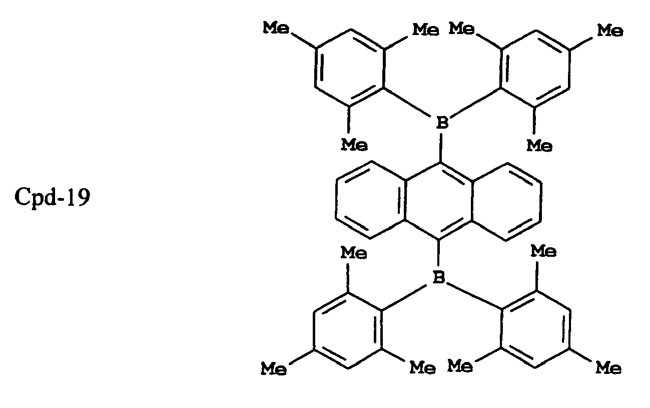

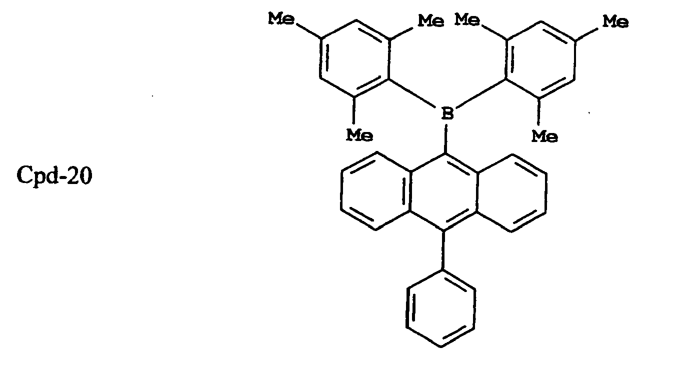

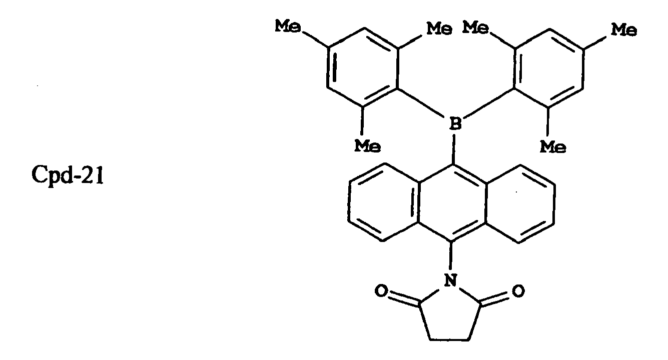

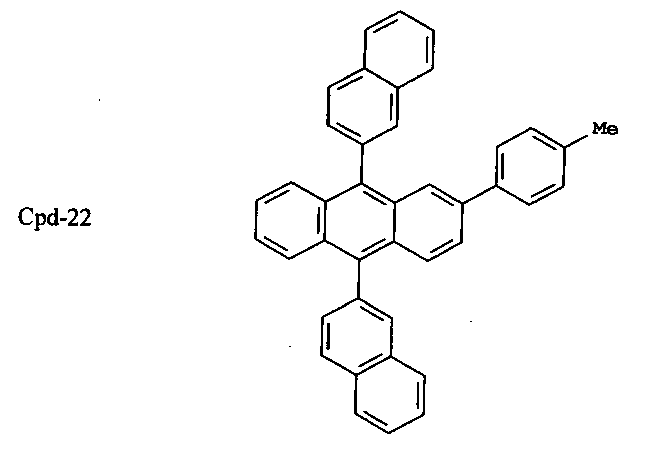

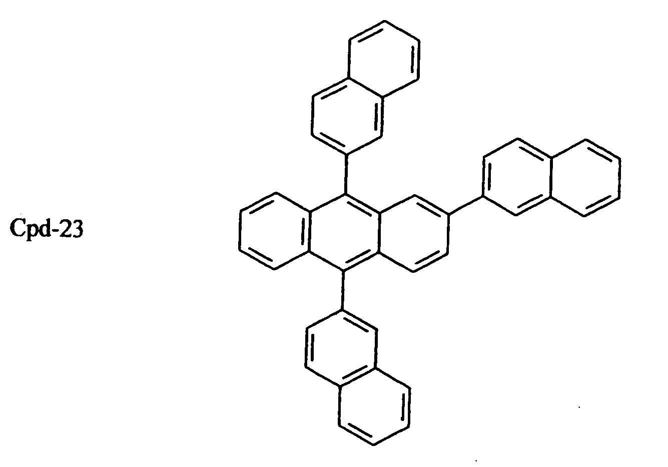

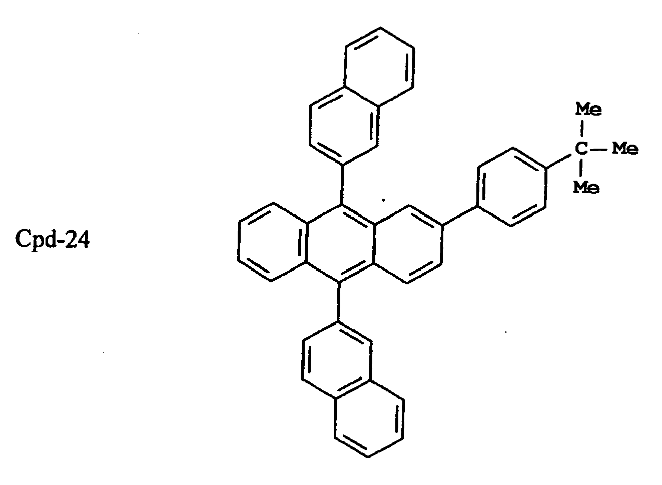

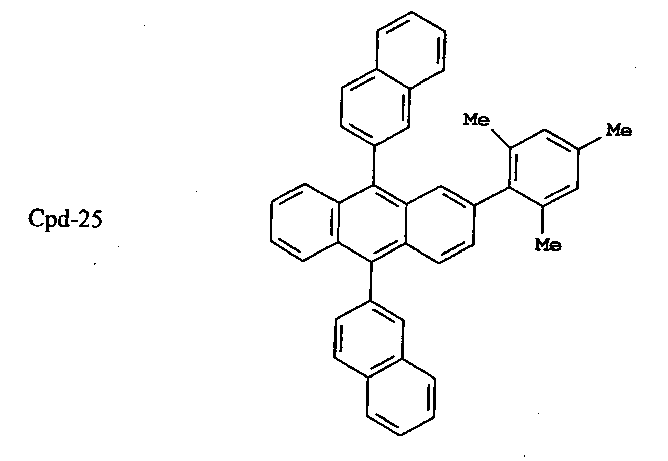

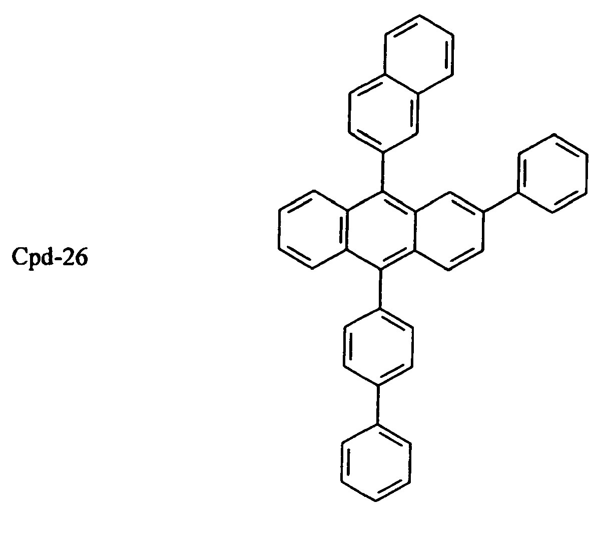

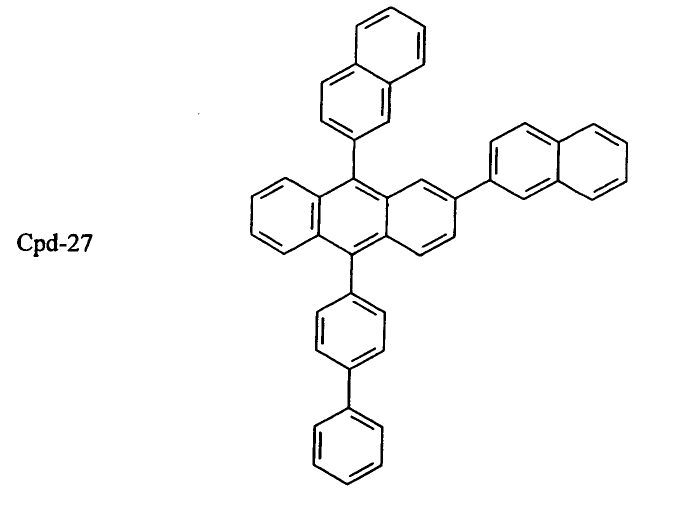

Desirably, the metal complex is present in the layer at a level of at least 1%, more commonly at a level of 5% or more, and frequently at a level of 10% or even 20% or greater by volume. In one embodiment, the complex is present at a level of 20-60% of the layer by volume. Overall, the complex or salt can be present in the balance amount of the carbocyclic aromatic fused ring compound.

In another aspect of the invention, the inventive layer also includes an elemental metal having a work function less than 4.2 eV. The definition of work function can be found in CRC Handbook of Chemistry and Physics, 70th Edition, 1989-1990, CRC Press Inc., page F-132 and a list of the work functions for various metals can be found on pages E-93 and E-94. Typical examples of such metals include Li, Na, K, Be, Mg, Ca, Sr, Ba, Y, La, Sm, Gd, Yb. In one desirable embodiment the metal is Li.

When included in the layer, the elemental metal is often present in the amount of from 0.1 % to 15%, commonly in the amount of 0.1 % to 10%, and often in the amount of 1 to 5% by volume of the total material in the layer.

In all described aspects of the invention, it should be understood that the inventive layer, further layer and additional layer applies to OLED devices that emit light by both fluorescence and phosphorescence. In other words, the OLED devices can be triple or singlet in nature. The advantages of the invention can be realized with both fluorescent and phosphorescent devices.

The thickness of the inventive layer may be between 0.5 and 200 nm, suitably between 2 and 100 nm, and desirably between 5 and 50 nm.

In one embodiment the dopant in the light-emitting layer is selected from derivatives of coumarin, rhodamine, quinacridone, or anthracene. Illustrative examples of the dopant in the light-emitting layer are the following: 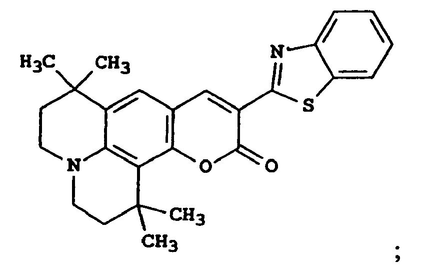 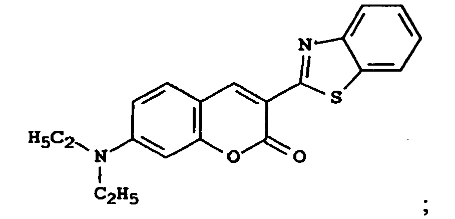 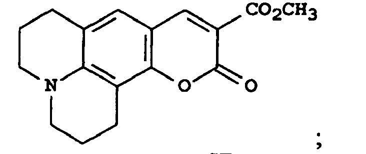 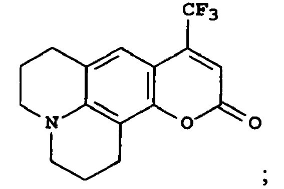 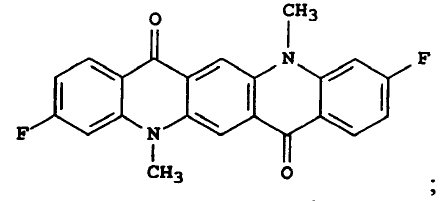 and

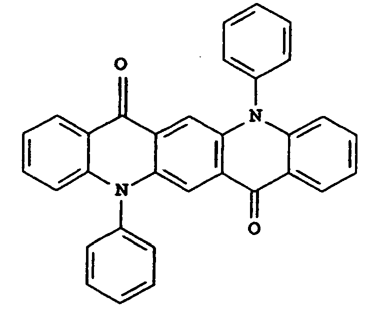

Another embodiment of the dopant in the light-emitting layer is represented by: 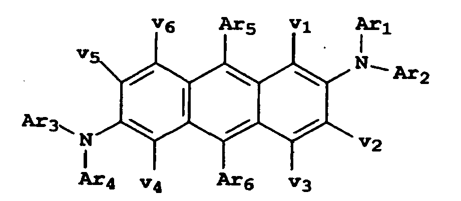 wherein Ar₁-Ar₆ independently represent an aryl group; and V₁- V₇ independently represent hydrogen or a substituent.

Further illustrative examples of the dopant in the light-emitting layer are the following: 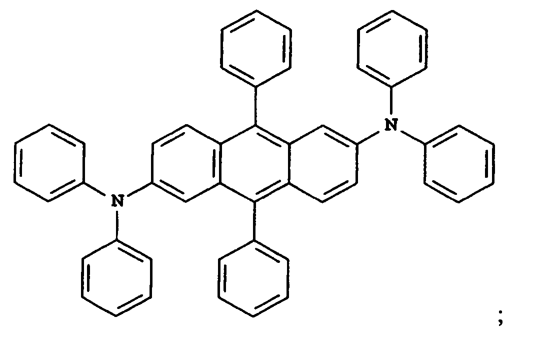 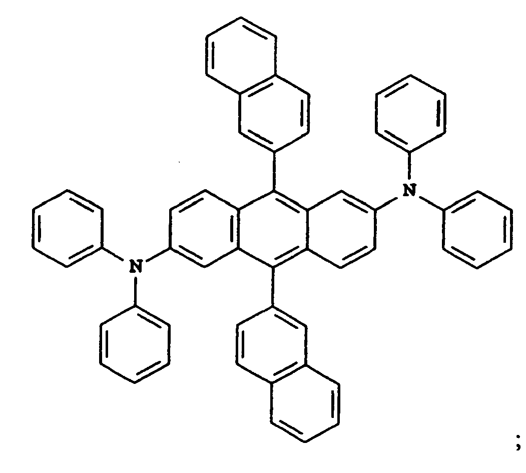 and

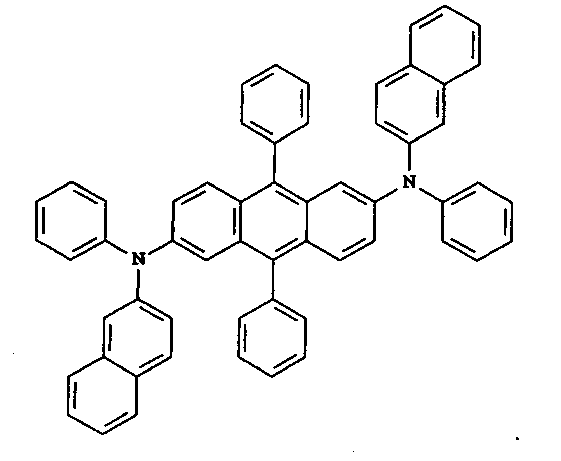

Unless otherwise specifically stated, use of the term "substituted" or "substituent" means any group or atom other than hydrogen. Additionally, when the term "group" is used, it means that when a substituent group contains a substitutable hydrogen, it is also intended to encompass not only the substituent's unsubstituted form, but also its form further substituted with any substituent group or groups as herein mentioned, so long as the substituent does not destroy properties necessary for device utility. Suitably, a substituent group may be halogen or may be bonded to the remainder of the molecule by an atom of carbon, silicon, oxygen, nitrogen, phosphorous, sulfur, selenium, or boron. The substituent may be, for example, halogen, such as chloro, bromo or fluoro; nitro; hydroxyl; cyano; carboxyl; or groups which may be further substituted, such as alkyl, including straight or branched chain or cyclic alkyl, such as methyl, trifluoromethyl, ethyl, *t-*butyl, 3-(2,4-di-*t-*pentylphenoxy) propyl, and tetradecyl; alkenyl, such as ethylene, 2-butene; alkoxy, such as methoxy, ethoxy, propoxy, butoxy, 2-methoxyethoxy, sec-butoxy, hexyloxy, 2-ethylhexyloxy, tetradecyloxy, 2-(2,4-di-*t-*pentylphenoxy)ethoxy, and 2-dodecyloxyethoxy; aryl such as phenyl, 4-*t-*butylphenyl, 2,4,6-trimethylphenyl, naphthyl; aryloxy, such as phenoxy, 2-methylphenoxy, alpha- or beta-naphthyloxy, and 4-tolyloxy; carbonamido, such as acetamido, benzamido, butyramido, tetradecanamido, alpha-(2,4-di-*t-*pentyl-phenoxy)acetamido, alpha-(2,4-di-*t-*pentylphenoxy)butyramido, alpha-(3-pentadecylphenoxy)-hexanamido, alpha-(4-hydroxy-3-*t-*butylphenoxy)-tetradecanamido, 2-oxo-pyrrolidin-1-yl, 2-oxo-5-tetradecylpyrrolin-1-yl, *N-*methyltetradecanamido, *N*-succinimido, *N*-phthalimido, 2,5-dioxo-1-oxazolidinyl, 3-dodecyl-2,5-dioxo-1-imidazolyl, and *N*-acetyl-*N*-dodecylamino, ethoxycarbonylamino, phenoxycarbonylamino, benzyloxycarbonylamino, hexadecyloxycarbonylamino, 2,4-di-*t-*butylphenoxycarbonylamino, phenylcarbonylamino, 2,5-(di-*t-*pentylphenyl)carbonylamino, *p-*dodecyl-phenylcarbonylamino, *p-*tolylcarbonylamino, *N*-methylureido, *N,N* dimethylureido, *N*-methyl-*N*-dodecylureido, *N*-hexadecylureido, *N*,*N-*dioctadecylureido, *N,N-*dioctyl-N'-ethylureido, *N*-phenylureido, *N,N-*diphenylureido, *N*-phenyl-*N*-*p*-tolylureido, *N*-(*m*-hexadecylphenyl)ureido, *N,N-*(2,5-di-*t*-pentylphenyl)-*N*'-ethylureido, and *t-*butylcarbonamido; sulfonamido, such as methylsulfonamido, benzenesulfonamido, *p-*tolylsulfonamido, *p-*dodecylbenzenesulfonamido, *N*-methyltetradecylsulfonamido, *N,N-*dipropylsulfamoylamino, and hexadecylsulfonamido; sulfamoyl, such as *N-*methylsulfamoyl, *N*-ethylsulfamoyl, *N*,*N*-dipropylsulfamoyl, *N-*hexadecylsulfamoyl, *N*,*N*-dimethylsulfamoyl, *N*-[3-(dodecyloxy)propyl]sulfamoyl, *N*-[4-(2,4-di-*t-*pentylphenoxy)butyl]sulfamoyl, *N*-methyl-*N*-tetradecylsulfamoyl, and *N*-dodecylsulfamoyl; carbamoyl, such as *N*-methylcarbamoyl, *N,N-*dibutylcarbamoyl, *N*-octadecylcarbamoyl, *N*-[4-(2,4-di-*t-*pentylphenoxy)butyl]carbamoyl, *N*-methyl-*N*-tetradecylcarbamoyl, and *N,N-*dioctylcarbamoyl; acyl, such as acetyl, (2,4-di-*t-*amylphenoxy)acetyl, phenoxycarbonyl, *p-*dodecyloxyphenoxycarbonyl methoxycarbonyl, butoxycarbonyl, tetradecyloxycarbonyl, ethoxycarbonyl, benzyloxycarbonyl, 3-pentadecyloxycarbonyl, and dodecyloxycarbonyl; sulfonyl, such as methoxysulfonyl, octyloxysulfonyl, tetradecyloxysulfonyl, 2-ethylhexyloxysulfonyl, phenoxysulfonyl, 2,4-di-*t-*pentylphenoxysulfonyl, methylsulfonyl, octylsulfonyl, 2-ethylhexylsulfonyl, dodecylsulfonyl, hexadecylsulfonyl, phenylsulfonyl, 4-nonylphenylsulfonyl, and *p-*tolylsulfonyl; sulfonyloxy, such as dodecylsulfonyloxy, and hexadecylsulfonyloxy; sulfinyl, such as methylsulfinyl, octylsulfinyl, 2-ethylhexylsulfinyl, dodecylsulfinyl, hexadecylsulfinyl, phenylsulfinyl, 4-nonylphenylsulfinyl, and *p-*tolylsulfinyl; thio, such as ethylthio, octylthio, benzylthio, tetradecylthio, 2-(2,4-di-*t-*pentylphenoxy)ethylthio, phenylthio, 2-butoxy-5-t-octylphenylthio, and *p-*tolylthio; acyloxy, such as acetyloxy, benzoyloxy, octadecanoyloxy, *p-*dodecylamidobenzoyloxy, *N*-phenylcarbamoyloxy, *N*-ethylcarbamoyloxy, and cyclohexylcarbonyloxy; amine, such as phenylanilino, 2-chloroanilino, diethylamine, dodecylamine; imino, such as 1 (*N*-phenylimido)ethyl, *N-*succinimido or 3-benzylhydantoinyl; phosphate, such as dimethylphosphate and ethylbutylphosphate; phosphite, such as diethyl and dihexylphosphite; a heterocyclic group, a heterocyclic oxy group or a heterocyclic thio group, each of which may be substituted and which contain a 3 to 7 membered heterocyclic ring composed of carbon atoms and at least one hetero atom selected from the group consisting of oxygen, nitrogen, sulfur, phosphorous, or boron. Such as 2-furyl, 2-thienyl, 2-benzimidazolyloxy or 2-benzothiazolyl; quaternary ammonium, such as triethylammonium; quaternary phosphonium, such as triphenylphosphonium; and silyloxy, such as trimethylsilyloxy.

If desired, the substituents may themselves be further substituted one or more times with the described substituent groups. The particular substituents used may be selected by those skilled in the art to attain desirable properties for a specific application and can include, for example, electron-withdrawing groups, electron-donating groups, and steric groups. When a molecule may have two or more substituents, the substituents may be joined together to form a ring such as a fused ring unless otherwise provided. Generally, the above groups and substituents thereof may include those having up to 48 carbon atoms, typically 1 to 36 carbon atoms and usually less than 24 carbon atoms, but greater numbers are possible depending on the particular substituents selected.

### General Device Architecture

The present invention can be employed in many EL device configurations using small molecule materials, oligomeric materials, polymeric materials, or combinations thereof. These include very simple structures comprising a single anode and cathode to more complex devices, such as passive matrix displays comprised of orthogonal arrays of anodes and cathodes to form pixels, and active-matrix displays where each pixel is controlled independently, for example, with thin film transistors (TFTs).

There are numerous configurations of the organic layers wherein the present invention can be successfully practiced. The essential requirements of an OLED are an anode, a cathode, and an organic light-emitting layer located between the anode and cathode. Additional layers may be employed as more fully described hereafter.

A typical structure according to the present invention and especially useful for a small molecule device, is shown in the Figure and is comprised of a substrate 101, an anode 103, a hole-injecting layer 105, a hole-transporting layer 107, a light-emitting layer 109, an electron-transporting layer 111, an electron injecting layer 112, and a cathode 113. These layers are described in detail below. Note that the substrate 101 may alternatively be located adjacent to the cathode 113, or the substrate 101 may actually constitute the anode 103 or cathode 113. The organic layers between the anode 103 and cathode 113 are conveniently referred to as the organic EL element. Also, the total combined thickness of the organic layers is desirably less than 500 nm. If the device includes phosphorescent material, a hole-blocking layer, located between the light-emitting layer and the electron-transporting layer, may be present.

The anode 103 and cathode 113 of the OLED are connected to a voltage/current source 150 through electrical conductors 160. The OLED is operated by applying a potential between the anode 103 and cathode 113 such that the anode 103 is at a more positive potential than the cathode 113. Holes are injected into the organic EL element from the anode 103 and electrons are injected into the organic EL element at the cathode 113. Enhanced device stability can sometimes be achieved when the OLED is operated in an AC mode where, for some time period in the AC cycle, the potential bias is reversed and no current flows. An example of an AC driven OLED is described in US 5,552,678.

### Substrate

The OLED device of this invention is typically provided over a supporting substrate 101 where either the cathode 113 or anode 103 can be in contact with the substrate. The electrode in contact with the substrate 101 is conveniently referred to as the bottom electrode. Conventionally, the bottom electrode is the anode 103, but this invention is not limited to that configuration. The substrate 101 can either be light transmissive or opaque, depending on the intended direction of light emission. The light transmissive property is desirable for viewing the EL emission through the substrate 101. Transparent glass or plastic is commonly employed in such cases. The substrate 101 can be a complex structure comprising multiple layers of materials. This is typically the case for active matrix substrates wherein TFTs are provided below the OLED layers. It is still necessary that the substrate 101, at least in the emissive pixelated areas, be comprised of largely transparent materials such as glass or polymers. For applications where the EL emission is viewed through the top electrode, the transmissive characteristic of the bottom support is immaterial, and therefore the substrate can be light transmissive, light absorbing or light reflective. Substrates for use in this case include, but are not limited to, glass, plastic, semiconductor materials such as silicon, ceramics, and circuit board materials. Again, the substrate 101 can be a complex structure comprising multiple layers of materials such as found in active matrix TFT designs. It is necessary to provide in these device configurations a light-transparent top electrode.

### Anode

When the desired electroluminescent light emission (EL) is viewed through the anode, the anode 103 should be transparent or substantially transparent to the emission of interest. Common transparent anode materials used in this invention are indium-tin oxide (ITO), indium-zinc oxide (IZO) and tin oxide, but other metal oxides can work including, but not limited to, aluminum- or indium-doped zinc oxide, magnesium-indium oxide, and nickel-tungsten oxide. In addition to these oxides, metal nitrides, such as gallium nitride, and metal selenides, such as zinc selenide, and metal sulfides, such as zinc sulfide, can be used as the anode 103. For applications where EL emission is viewed only through the cathode 113, the transmissive characteristics of the anode 103 are immaterial and any conductive material can be used, transparent, opaque or reflective. Example conductors for this application include, but are not limited to, gold, iridium, molybdenum, palladium, and platinum. Typical anode materials, transmissive or otherwise, have a work function of 4.1 eV or greater. Desired anode materials are commonly deposited by any suitable means such as evaporation, sputtering, chemical vapor deposition, or electrochemical means. Anodes can be patterned using well-known photolithographic processes. Optionally, anodes may be polished prior to application of other layers to reduce surface roughness so as to minimize short circuits or enhance reflectivity.

### Cathode

When light emission is viewed solely through the anode 103, the cathode 113 used in this invention can be comprised of nearly any conductive material. Desirable materials have good film-forming properties to ensure good contact with the underlying organic layer, promote electron injection at low voltage, and have good stability. Useful cathode materials often contain a low work function metal (< 4.0 eV) or metal alloy. One useful cathode material is comprised of a Mg:Ag alloy wherein the percentage of silver is in the range of 1 to 20 %, as described in U.S. Patent No. 4,885,221. Another suitable class of cathode materials includes bilayers comprising the cathode and a thin electron-injection layer (EIL) in contact with an organic layer (e.g., an electron transporting layer (ETL)), the cathode being capped with a thicker layer of a conductive metal. Here, the EIL preferably includes a low work function metal or metal salt, and if so, the thicker capping layer does not need to have a low work function. One such cathode is comprised of a thin layer of LiF followed by a thicker layer of Al as described in U.S. Patent No. 5,677,572. An ETL material doped with an alkali metal, for example, Li-doped Alq, is another example of a useful EIL. Other useful cathode material sets include, but are not limited to, those disclosed in U.S. Patent Nos. 5,059,861, 5,059,862, and 6,140,763.

When light emission is viewed through the cathode, the cathode 113 must be transparent or nearly transparent. For such applications, metals must be thin or one must use transparent conductive oxides, or a combination of these materials. Optically transparent cathodes have been described in more detail in US 4,885,211, US 5,247,190, JP 3,234,963, US 5,703,436, US 5,608,287, US 5,837,391, US 5,677,572, US 5,776,622, US 5,776,623, US 5,714,838, US 5,969,474, US 5,739,545, US 5,981,306, US 6,137,223, US 6,140,763, US 6,172,459, EP 1 076 368, US 6,278,236, and US 6,284,3936. Cathode materials are typically deposited by any suitable method such as evaporation, sputtering, or chemical vapor deposition. When needed, patterning can be achieved through many well known methods including, but not limited to, through-mask deposition, integral shadow masking as described in US 5,276,380 and EP 0 732 868, laser ablation, and selective chemical vapor deposition.

### Hole-Injecting Layer (HIL)

Depending on the aspect of the invention, the device may include a HIL of the invention or an HIL as known in the art, or both. A hole-injecting layer 105 may be provided between anode 103 and hole-transporting layer 107. The hole-injecting layer can serve to improve the film formation property of subsequent organic layers and to facilitate injection of holes into the hole-transporting layer 107. Suitable materials for use in the hole-injecting layer 105 include, but are not limited to, porphyrinic compounds as described in US 4,720,432, plasma-deposited fluorocarbon polymers as described in US 6,208,075, and some aromatic amines, for example, MTDATA (4,4',4"-tris[(3-methylphenyl)phenylamino]triphenylamine). Alternative hole-injecting materials reportedly useful in organic EL devices are described in EP 0 891 121 A1 and EP 1 029 909 A1. A hole-injection layer is conveniently used in the present invention, and is desirably a plasma-deposited fluorocarbon polymer. The thickness of a hole-injection layer containing a plasma-deposited fluorocarbon polymer can be in the range of 0.2 nm to 15 nm and suitably in the range of 0.3 to 1.5 nm.

### Hole-Transporting Layer (HTL)

While not always necessary, it is often useful to include a hole-transporting layer in an OLED device. The hole-transporting layer 107 of the organic EL device contains at least one hole-transporting compound such as an aromatic tertiary amine. An aromatic tertiary amine is understood to be a compound containing at least one trivalent nitrogen atom that is bonded only to carbon atoms, at least one of which is a member of an aromatic ring. In one form the aromatic tertiary amine can be an arylamine, such as a monoarylamine, diarylamine, triarylamine, or a polymeric arylamine. Exemplary monomeric triarylamines are illustrated by Klupfel et al. US 3,180,730. Other suitable triarylamines substituted with one or more vinyl radicals and/or comprising at least one active hydrogen containing group are disclosed by Brantley et al US 3,567,450 and US 3,658,520.

A more preferred class of aromatic tertiary amines is those which include at least two aromatic tertiary amine moieties as described in US 4,720,432 and US 5,061,569. Such compounds include those represented by structural formula (A). 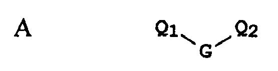 wherein Q₁ and Q₂ are independently selected aromatic tertiary amine moieties and G is a linking group such as an arylene, cycloalkylene, or alkylene group of a carbon to carbon bond. In one embodiment, at least one of Q₁ or Q₂ contains a polycyclic fused ring structure, e.g., a naphthalene. When G is an aryl group, it is conveniently a phenylene, biphenylene, or naphthalene moiety.

A useful class of triarylamines satisfying structural formula (A) and containing two triarylamine moieties is represented by structural formula (B): 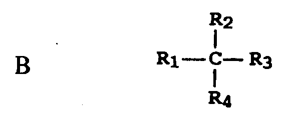 where
R₁ and R₂ each independently represents a hydrogen atom, an aryl group, or an alkyl group or R₁ and R₂ together represent the atoms completing a cycloalkyl group; and
R₃ and R₄ each independently represents an aryl group, which is in turn substituted with a diaryl substituted amino group, as indicated by structural formula (C): 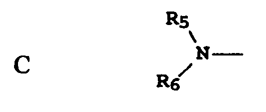 wherein R₅ and R₆ are independently selected aryl groups. In one embodiment, at least one of R₅ or R₆ contains a polycyclic fused ring structure, e.g., a naphthalene.

Another class of aromatic tertiary amines is the tetraaryldiamines. Desirable tetraaryldiamines include two diarylamino groups, such as indicated by formula (C), linked through an arylene group. Useful tetraaryldiamines include those represented by formula (D). 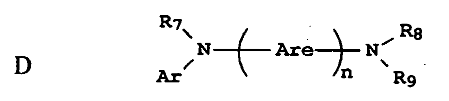 wherein
each Are is an independently selected arylene group, such as a phenylene or anthracene moiety,
n is an integer of from 1 to 4, and
Ar, R₇, R₈, and R₉ are independently selected aryl groups.

In a typical embodiment, at least one of Ar, R₇, R₈, and R₉ is a polycyclic fused ring structure, e.g., a naphthalene.

The various alkyl, alkylene, aryl, and arylene moieties of the foregoing structural formulae (A), (B), (C), (D), can each in turn be substituted. Typical substituents include alkyl groups, alkoxy groups, aryl groups, aryloxy groups, and halide such as fluoride, chloride, and bromide. The various alkyl and alkylene moieties typically contain from 1 to 6 carbon atoms. The cycloalkyl moieties can contain from 3 to 10 carbon atoms, but typically contain five, six, or seven ring carbon atoms--e.g., cyclopentyl, cyclohexyl, and cycloheptyl ring structures. The aryl and arylene moieties are usually phenyl and phenylene moieties.

The hole-transporting layer can be formed of a single tertiary amine compound or a mixture of such compounds. Specifically, one may employ a triarylamine, such as a triarylamine satisfying the formula (B), in combination with a tetraaryldiamine, such as indicated by formula (D). Illustrative of useful aromatic tertiary amines are the following:
1,1-Bis(4-di-p-tolylaminophenyl)cyclohexane (TAPC)
1,1-Bis(4-di-p-tolylaminophenyl)-4-methylcyclohexane
1,1-Bis(4-di-p-tolylaminophenyl)-4-phenylcyclohexane
1,1-Bis(4-di-p-tolylaminophenyl)-3-phenylpropane (TAPPP)
N,N,N',N'-tetraphenyl-4,4"'-diamino-1,1 ':4', 1 ":4", 1 "'-quaterphenyl
Bis(4-dimethylamino-2-methylphenyl)phenylmethane
1,4-bis[2-[4-[N,N-di(p-toly)amino]phenyl]vinyl]benzene (BDTAPVB)
N,N,N',N'-Tetra-p-tolyl-4,4'-diaminobiphenyl (TTB)
N,N,N',N'-Tetraphenyl-4,4'-diaminobiphenyl
N,N,N',N'-tetra- I -naphthyl-4,4'-diaminobiphenyl
N,N,N',N'-tetra-2-naphthyl-4,4'-diaminobiphenyl
N-Phenylcarbazole
4,4'-Bis[N-(1-naphthyl)-N-phenylamino]biphenyl (NPB)
4,4'-Bis[N-(1-naphthyl)-N-(2-naphthyl)amino]biphenyl (TNB)
4,4'-Bis[N-(1-naphthyl)-N-phenylamino]p-terphenyl
4,4'-Bis[N-(2-naphthyl)-N-phenylamino]biphenyl
4,4'-Bis[N-(3-acenaphthenyl)-N-phenylamino]biphenyl
1,5-Bis[N-(1-naphthyl)-N-phenylamino]naphthalene
4,4'-Bis[N-(9-anthryl)-N-phenylamino]biphenyl
4,4'-Bis[N-(1-anthryl)-N-phenylamino]-p-terphenyl
4,4'-Bis[N-(2-phenanthryl)-N-phenylamino]biphenyl
4,4'-Bis[N-(8-fluoranthenyl)-N-phenylamino]biphenyl
4,4'-Bis[N-(2-pyrenyl)-N-phenylamino]biphenyl
4,4'-Bis[N-(2-naphthacenyl)-N-phenylamino]biphenyl
4,4'-Bis[N-(2-perylenyt)-N-phenylamino]biphenyl
4,4'-Bis[N-(1-coronenyl)-N-phenylamino]biphenyl
2,6-Bis(di-p-tolylamino)naphthalene
2,6-Bis[di-(1-naphthyl)amino]naphthalene
2,6-Bis[N-(1-naphthyl)-N-(2-naphthyl)amino]naphthalene
N,N,N',N'-Tetra(2-naphthyl)-4,4"-diamino-p-terphenyl
4,4'-Bis{N-phenyl-N-[4-(1-naphthyl)-phenyl]amino} biphenyl
2,6-Bis[N,N-di(2-naphthyl)amino]fluorene
4,4',4"-tris[(3-methylphenyl)phenylamino]triphenylamine (MTDATA)
4,4'-Bis[N-(3-methylphenyl)-N-phenylamino]biphenyl (TPD)

Another class of useful hole-transporting materials includes polycyclic aromatic compounds as described in EP 1 009 041. Tertiary aromatic amines with more than two amine groups may be used including oligomeric materials. In addition, polymeric hole-transporting materials can be used such as poly(N-vinylcarbazole) (PVK), polythiophenes, polypyrrole, polyaniline, and copolymers such as poly(3,4-ethylenedioxythiophene) / poly(4-styrenesulfonate) also called PEDOT/PSS. It is also possible for the hole-transporting layer to comprise two or more sublayers of differing compositions, the composition of each sublayer being as described above. The thickness of the hole-transporting layer can be between 10 and 500 nm and suitably between 50 and 300 nm.

### Light-Emitting Layer (LEL)

As more fully described in U.S. Patent Nos. 4,769,292 and 5,935,721, the light-emitting layer (LEL) of the organic EL element includes a luminescent material where electroluminescence is produced as a result of electron-hole pair recombination. The light-emitting layer can be comprised of a single material, but more commonly consists of a host material doped with a guest emitting material or materials where light emission comes primarily from the emitting materials and can be of any color. The host materials in the light-emitting layer can be an electron-transporting material, as defined below, a hole-transporting material, as defined above, or another material or combination of materials that support hole-electron recombination. Fluorescent emitting materials are typically incorporated at 0.01 to 10 % by weight of the host material.

The host and emitting materials can be small non-polymeric molecules or polymeric materials such as polyfluorenes and polyvinylarylenes (e.g., poly(p-phenylenevinylene), PPV). In the case of polymers, small-molecule emitting materials can be molecularly dispersed into a polymeric host, or the emitting materials can be added by copolymerizing a minor constituent into a host polymer. Host materials may be mixed together in order to improve film formation, electrical properties, light emission efficiency, operating lifetime, or manufacturability. The host may comprise a material that has good hole-transporting properties and a material that has good electron-transporting properties.

An important relationship for choosing a fluorescent material as a guest emitting material is a comparison of the excited singlet-state energies of the host and the fluorescent material. It is highly desirable that the excited singlet-state energy of the fluorescent material be lower than that of the host material. The excited singlet-state energy is defined as the difference in energy between the emitting singlet state and the ground state. For non-emissive hosts, the lowest excited state of the same electronic spin as the ground state is considered the emitting state.

Host and emitting materials known to be of use include, but are not limited to, those disclosed in US 4,768,292, US 5,141,671, US 5,150,006, US 5,151,629, US 5,405,709, US 5,484,922, US 5,593,788, US 5,645,948, US 5,683,823, US 5,755,999, US 5,928,802, US 5,935,720, US 5,935,721, and US 6,020,078.

Metal complexes of 8-hydroxyquinoline and similar derivatives, also known as metal-chelated oxinoid compounds (Formula E), constitute one class of useful host compounds capable of supporting electroluminescence, and are particularly suitable for light emission of wavelengths longer than 500 nm, e.g., green, yellow, orange, and red. 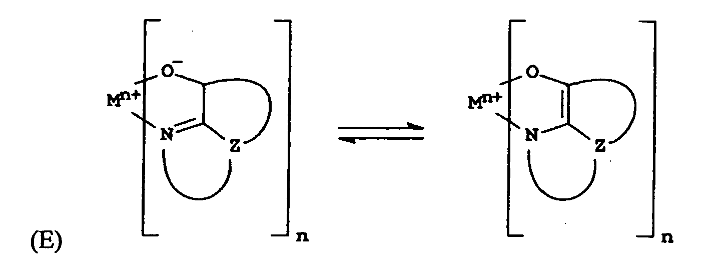 wherein
M represents a metal;
n is an integer of from 1 to 4; and
Z independently in each occurrence represents the atoms completing a nucleus having at least two fused aromatic rings.

From the foregoing it is apparent that the metal can be monovalent, divalent, trivalent, or tetravalent metal. The metal can, for example, be an alkali metal, such as lithium, sodium, or potassium; an alkaline earth metal, such as magnesium or calcium; a trivalent metal, such aluminum or gallium, or another metal such as zinc or zirconium. Generally any monovalent, divalent, trivalent, or tetravalent metal known to be a useful chelating metal can be employed.

Z completes a heterocyclic nucleus containing at least two fused aromatic rings, at least one of which is an azole or azine ring. Additional rings, including both aliphatic and aromatic rings, can be fused with the two required rings, if required. To avoid adding molecular bulk without improving on function the number of ring atoms is usually maintained at 18 or less.

Illustrative of useful chelated oxinoid compounds are the following:
CO-1: Aluminum trisoxine [alias, tris(8-quinolinolato)aluminum(III)]
CO-2: Magnesium bisoxine [alias, bis(8-quinolinolato)magnesium(II)]
CO-3: Bis[benzo{f}-8-quinolinolato]zinc (II)
CO-4: Bis(2-methyl-8-quinolinolato)aluminum(III)-0-oxo-bis(2-methyl-8-quinolinolato) aluminum(III)
CO-5: Indium trisoxine [alias, tris(8-quinolinolato)indium]
CO-6: Aluminum tris(5-methyloxine) [alias, tris(5-methyl-8-quinolinolato) aluminum(III)]
CO-7: Lithium oxine [alias, (8-quinolinolato)lithium(I)]
CO-8: Gallium oxine [alias, tris(8-quinolinolato)gallium(III)]
CO-9: Zirconium oxine [alias, tetra(8-quinolinolato)zirconium(IV)]

Benzazole derivatives (Formula G) constitute another class of useful host materials capable of supporting electroluminescence, and are particularly suitable for light emission of wavelengths longer than 400 nm, e.g., blue, green, yellow, orange or red. 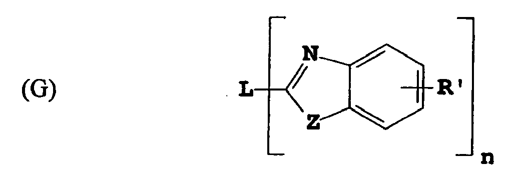 wherein:
n is an integer of 3 to 8;
Z is O, NR or S; and
R and R' are individually hydrogen; alkyl of from 1 to 24 carbon atoms, for example, propyl, t-butyl, heptyl, and the like; aryl or hetero-atom substituted aryl of from 5 to 20 carbon atoms for example phenyl and naphthyl, furyl, thienyl, pyridyl, quinolinyl and other heterocyclic systems; or halo such as chloro, fluoro; or atoms necessary to complete a fused aromatic ring; and
L is a linkage unit consisting of alkyl, aryl, substituted alkyl, or substituted aryl, which connects the multiple benzazoles together. L may be either conjugated with the multiple benzazoles or not in conjugation with them. An example of a useful benzazole is 2,2',2"-(1,3,5-phenylene)tris[1-phenyl-1H-benzimidazole]. Styrylarylene derivatives as described in U.S. Patent 5,121,029 and JP 08333569 are also useful hosts for blue emission. For example, 9,10-bis[4-(2,2-diphenylethenyl)phenyl]anthracene and 4,4'-bis(2,2-diphenylethenyl)-1, 1'-biphenyl (DPVBi) are useful hosts for blue emission.

Useful fluorescent emitting materials include, but are not limited to, derivatives of anthracene, tetracene, xanthene, perylene, rubrene, coumarin, rhodamine, and quinacridone, dicyanomethylenepyran compounds, thiopyran compounds, polymethine compounds, pyrylium and thiapyrylium compounds, fluorene derivatives, periflanthene derivatives, indenoperylene derivatives, bis(azinyl)imine boron compounds, bis(azinyl)methene compounds, and carbostyryl compounds. Illustrative examples of useful materials include, but are not limited to, the following:

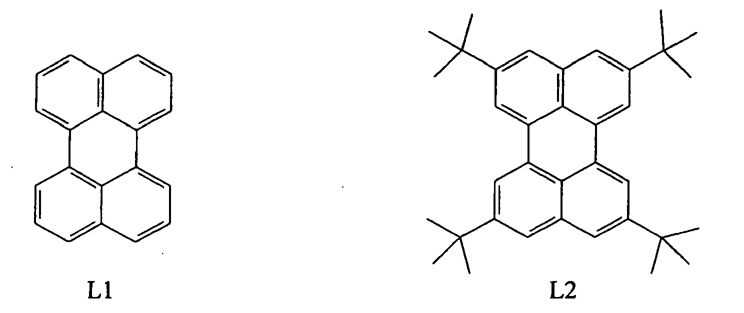

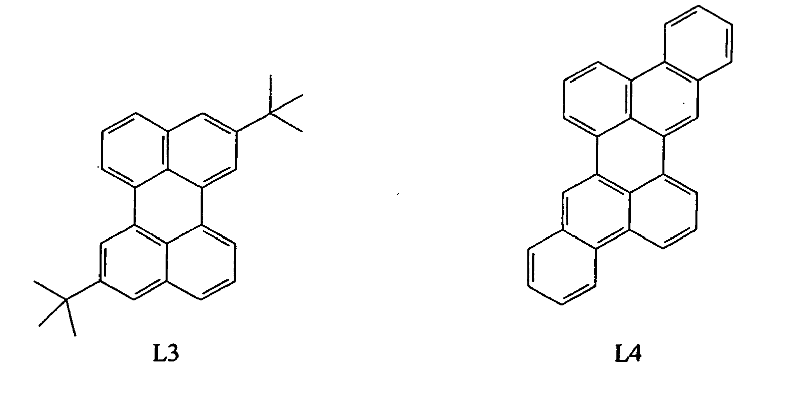

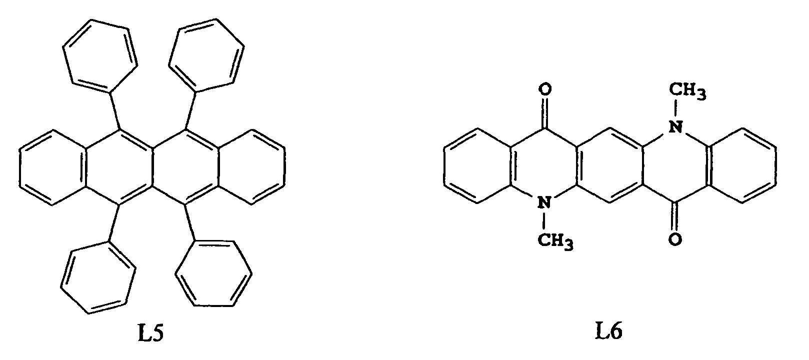

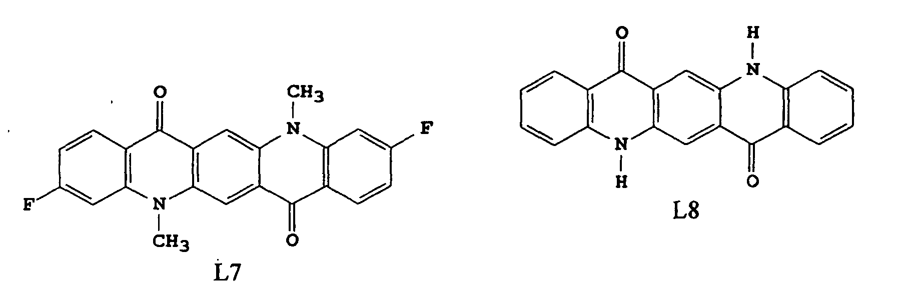

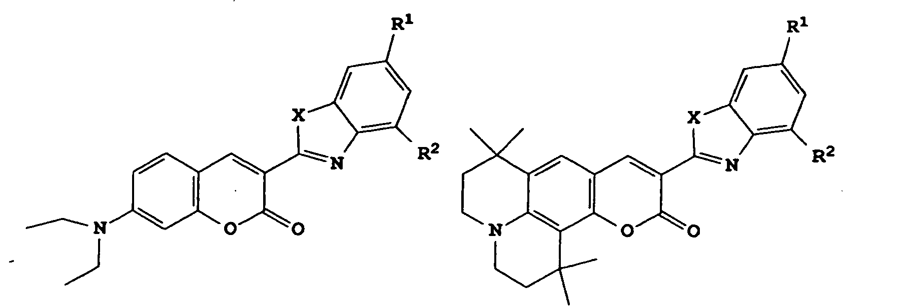

| | X | R1 | R2 | | X | R1 | R2 |
|---|---|---|---|---|---|---|---|
| L9 | O | H | H | L23 | O | H | H |
| L10 | O | H | Methyl | L24 | O | H | Methyl |
| L11 | O | Methyl | H | L25 | O | Methyl | H |
| L12 | O | Methyl | Methyl | L26 | O | Methyl | Methyl |
| L13 | O | H | t-butyl | L27 | O | H | t-butyl |
| L14 | O | t-butyl | H | L28 | O | t-butyl | H |
| L15 | O | t-butyl | t-butyl | L29 | O | t-butyl | t-butyl |
| L16 | S | H | H | L30 | S | H | H |
| L17 | S | H | Methyl | L31 | S | H | Methyl |
| L18 | S | Methyl | H | L32 | S | Methyl | H |
| L19 | S | Methyl | Methyl | L33 | S | Methyl | Methyl |
| L20 | S | H | t-butyl | L34 | S | H | t-butyl |
| L21 | S | t-butyl | H | L35 | S | t-butyl | H |
| L22 | S | t-butyl | t-butyl | L36 | S | t-butyl | t-butyl |

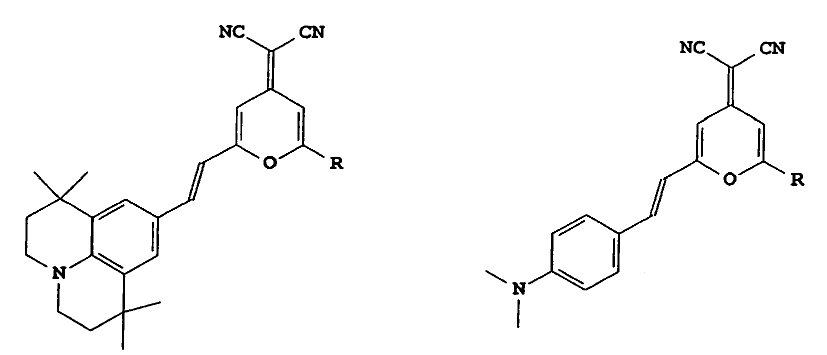

| | R | | R |
|---|---|---|---|
| L37 | phenyl | LA1 | Phenyl |
| L38 | methyl | L42 | Methyl |
| L39 | t-butyl | L43 | t-butyl |
| L40 | mesityl | L44 | Mesityl |

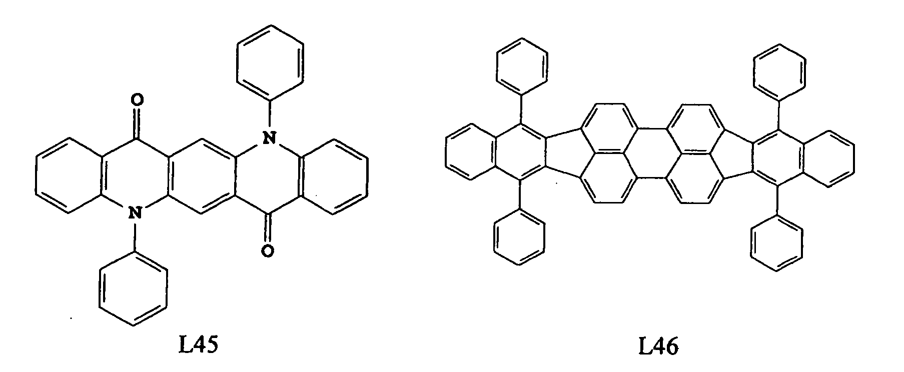

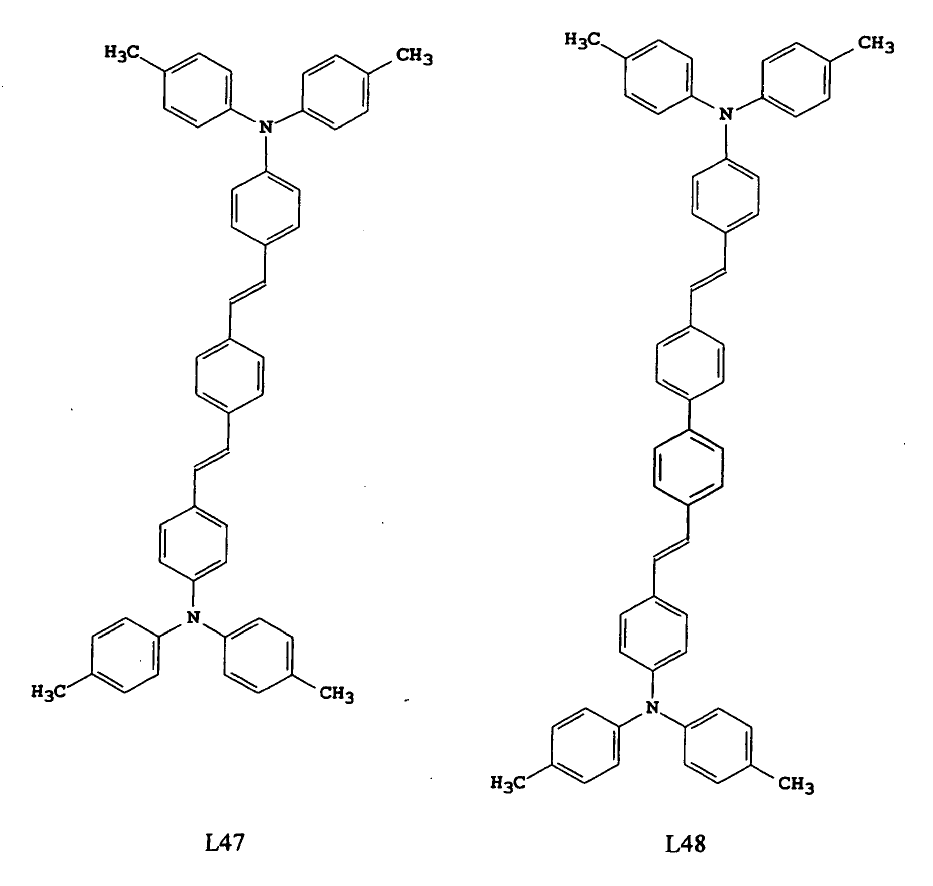

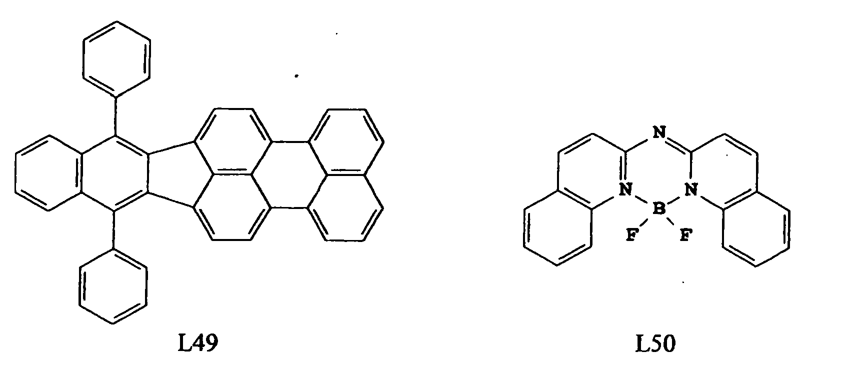

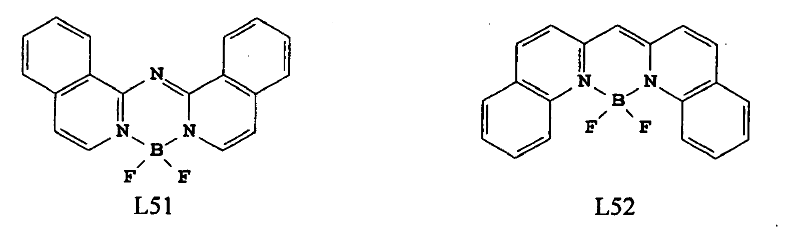

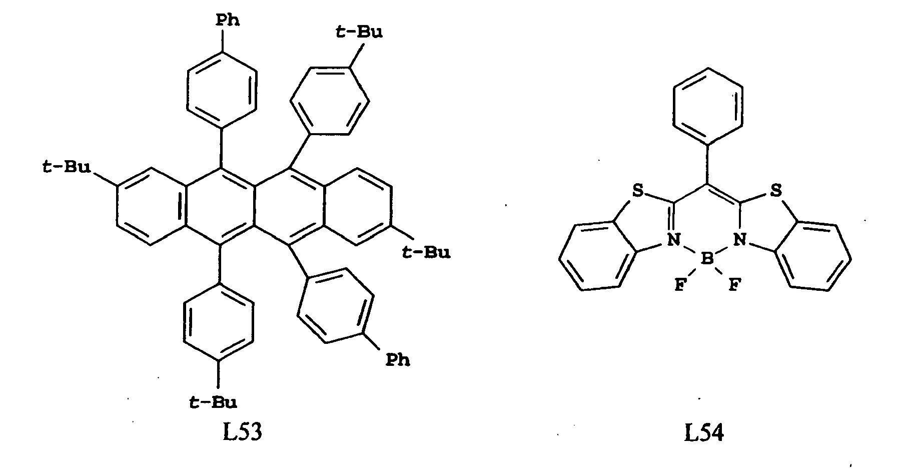

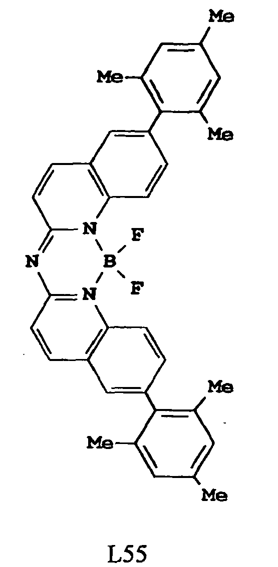

Light-emitting phosphorescent materials may be used in the EL device. For convenience, the phosphorescent complex guest material may be referred to herein as a phosphorescent material. The phosphorescent material typically includes one or more ligands, for example monoanionic ligands that can be coordinated to a metal through an sp² carbon and a heteroatom. Conveniently, the ligand can be phenylpyridine (ppy) or derivatives or analogs thereof. Examples of some useful phosphorescent organometallic materials include tris(2-phenylpyridinato-N,C^{2'})iridium(III), bis(2-phenylpyridinato-N,C²)iridium(III)(acetylacetonate), and bis(2-phenylpyridinato-N,C²')platinum(II). Usefully, many phosphorescent organometallic materials emit in the green region of the spectrum, that is, with a maximum emission in the range of 510 to 570 nm.

Phosphorescent materials may be used singly or in combinations other phosphorescent materials, either in the same or different layers. Phosphorescent materials and suitable hosts are described in WO 00/57676, WO 00/70655, WO 01/41512 A1, WO 02/15645 A1, US 2003/0017361 A1, WO 01/93642 A1, WO 01/39234 A2, US 6,458,475 B1, WO 02/071813 A1, US 6,573,651 B2, US 2002/0197511 A1, WO 02/074015 A2, US 6,451,455 B1, US 2003/ 0072964 A1, US 2003 / 0068528 A1, US 6,413,656 B1, US 6,515,298 B2, US 6,451,415 B1, US 6,097,147, US 2003/0124381 A1, US 2003/0059646 A1, US 2003/0054198 A1, EP 1 239 526 A2, EP 1 238 981 A2, EP 1 244 155 A2, US 2002/0100906 A1, US 2003 / 0068526 A1, US 2003/0068535 A1, JP 2003073387A, JP 2003 073388A, US 2003/0141809 A1, US 2003/0040627 A1, JP 2003059667A, JP 2003073665A, and US 2002/0121638 A1.

The emission wavelengths of cyclometallated Ir(III) complexes of the type IrL₃ and IrL₂L', such as the green-emitting fac-tris(2-phenylpyridinato-N,C²')iridium(III) and bis(2-phenylpyridinato-N,C^{2'})iridium(III)(acetylacetonate) may be shifted by substitution of electron donating or withdrawing groups at appropriate positions on the cyclometallating ligand L, or by choice of different heterocycles for the cyclometallating ligand L. The emission wavelengths may also be shifted by choice of the ancillary ligand L'. Examples of red emitters are the bis(2-(2'-benzothienyl)pyridinato-N,C^{3'})iridium(III)(acetylacetonate) and tris(2-phenylisoquinolinato-N,C)iridium(II). A blue-emitting example is bis(2-(4,6-difluorophenyl)-pyridinato-N,C^{2'})iridium(III)(picolinate).

Red electrophosphorescence has been reported, using bis(2-(2'-benzo[4,5-a]thienyl)pyridinato-N, C³) iridium (acetylacetonate) [Btp₂Ir(acac)] as the phosphorescent material (C. Adachi, S. Lamansky, M. A. Baldo, R. C. Kwong, M. E. Thompson, and S. R. Forrest, App. Phys. Lett., 78, 1622-1624 (2001)).

Other important phosphorescent materials include cyclometallated Pt(II) complexes such as cis-bis(2-phenylpyridinato-N,C^{2'})platinum(II), cis-bis(2-(2'-thienyl)pyridinato-N,C^{3'}) platinum(II), cis-bis(2-(2'-thienyl)quinolinato-N,C^{5'}) platinum(II), or (2-(4,6-difluorophenyl)pyridinato-N,C^{2'}) platinum (II) (acetylacetonate). Pt (II) porphyrin complexes such as 2,3,7,8,12,13,17,18-octaethyl-21H, 23H-porphine platinum(II) are also useful phosphorescent materials.

Still other examples of useful phosphorescent materials include coordination complexes of the trivalent lanthanides such as Tb³⁺ and Eu³⁺ (J. Kido et al., Appl. Phys. Lett., 65, 2124 (1994)).

Suitable host materials for phosphorescent materials should be selected so that transfer of a triplet exciton can occur efficiently from the host material to the phosphorescent material but cannot occur efficiently from the phosphorescent material to the host material. Therefore, it is highly desirable that the triplet energy of the phosphorescent material be lower than the triplet energy of the host. Generally speaking, a large triplet energy implies a large optical bandgap. However, the band gap of the host should not be chosen so large as to cause an unacceptable barrier to injection of charge carriers into the light-emitting layer and an unacceptable increase in the drive voltage of the OLED. Suitable host materials are described in WO 00/70655 A2; 01/39234 A2; 01/ 93642 A1; 02/074015 A2; 02/15645 A1, and US 20020117662. Suitable hosts include certain aryl amines, triazoles, indoles and carbazole compounds. Examples of desirable hosts are 4,4'-N,N'-dicarbazole-biphenyl, otherwise known as 4,4'-bis(carbazol-9-yl)biphenyl or CBP; 4,4'-N,N'-dicarbazole-2,2'-dimethyl-biphenyl, otherwise known as 2,2'-dimethyl-4,4'-bis(carbazol-9-yl)biphenyl or CDBP; 1,3-bis(N,N'-dicarbazole)benzene, otherwise known as 1,3-bis(carbazol-9-yl)benzene, and poly(N-vinylcarbazole), including their derivatives.

Desirable host materials are capable of forming a continuous film.

### Hole-Blocking Layer (HBL)

In addition to suitable hosts, an OLED device employing a phosphorescent material often requires at least one hole-blocking layer placed between the electron-transporting layer 111 and the light-emitting layer 109 to help confine the excitons and recombination events to the light-emitting layer comprising the host and phosphorescent material. In this case, there should be an energy barrier for hole migration from the host into the hole-blocking layer, while electrons should pass readily from the hole-blocking layer into the light-emitting layer comprising a host and a phosphorescent material. The first requirement entails that the ionization potential of the hole-blocking layer be larger than that of the light-emitting layer 109, desirably by 0.2 eV or more. The second requirement entails that the electron affinity of the hole-blocking layer not greatly exceed that of the light-emitting layer 109, and desirably be either less than that of light-emitting layer or not exceed that of the light-emitting layer by more than 0.2 eV.

When used with an electron-transporting layer whose characteristic luminescence is green, such as an Alq-containing electron-transporting layer as described below, the requirements concerning the energies of the highest occupied molecular orbital (HOMO) and lowest unoccupied molecular orbital (LUMO) of the material of the hole-blocking layer frequently result in a characteristic luminescence of the hole-blocking layer at shorter wavelengths than that of the electron-transporting layer, such as blue, violet, or ultraviolet luminescence. Thus, it is desirable that the characteristic luminescence of the material of a hole-blocking layer be blue, violet, or ultraviolet. It is further desirable, but not absolutely required, that the triplet energy of the hole-blocking material be greater than that of the phosphorescent material. Suitable hole-blocking materials are described in WO 00/70655A2 and WO 01/93642 A1. Two examples of useful hole-blocking materials are bathocuproine (BCP) and bis(2-methyl-8-quinolinolato)(4-phenylphenolato)aluminum(III) (BAlq). The characteristic luminescence of BCP is in the ultraviolet, and that of BAlq is blue. Metal complexes other than BAlq are also known to block holes and excitons as described in US 20030068528. In addition, US 20030175553 A1 describes the use of fac-tris(1-phenylpyrazolato-N,C²)iridium(III) (Irppz) for this purpose.

When a hole-blocking layer is used, its thickness can be between 2 and 100 nm and suitably between 5 and 10 nm.

### Electron-Transporting Layer (ETL)

In one embodiment, the layer of the invention functions as the only electron-transporting layer of the device. In other embodiments it may be desirable to have additional electron-transporting layers as described below.

Desirable thin film-forming materials for use in forming electron-transporting layer of organic EL devices are metal-chelated oxinoid compounds, including chelates of oxine itself (also commonly referred to as 8-quinolinol or 8-hydroxyquinoline). Such compounds help to inject and transport electrons, exhibit high levels of performance, and are readily fabricated in the form of thin films. Exemplary of contemplated oxinoid compounds are those satisfying structural formula (E), previously described.

Other electron-transporting materials suitable for use in the electron-transporting layer include various butadiene derivatives as disclosed in US 4,356,429 and various heterocyclic optical brighteners as described in US 4,539,507. Benzazoles satisfying structural formula (G) are also useful electron transporting materials. Triazines are also known to be useful as electron transporting materials.

If both a hole-blocking layer and an electron-transporting layer 111 are used, electrons should pass readily from the electron-transporting layer 111 into the hole-blocking layer. Therefore, the electron affinity of the electron-transporting layer 111 should not greatly exceed that of the hole-blocking layer. Desirably, the electron affinity of the electron-transporting layer should be less than that of the hole-blocking layer or not exceed it by more than 0.2 eV.

If an electron-transporting layer is used, its thickness may be between 2 and 100 nm and suitably between 5 and 20 nm.

### Other Useful Organic Layers and Device Architecture

In some instances, layers 109 through 111 can optionally be collapsed into a single layer that serves the function of supporting both light emission and electron transportation. The hole-blocking layer, when present, and layer 111 may also be collapsed into a single layer that functions to block holes or excitons, and supports electron transport. It also known in the art that emitting materials may be included in the hole-transporting layer 107. In that case, the hole-transporting material may serve as a host. Multiple materials may be added to one or more layers in order to create a white-emitting OLED, for example, by combining blue- and yellow-emitting materials, cyan- and red-emitting materials, or red-, green-, and blue-emitting materials. White-emitting devices are described, for example, in EP 1 187 235, US 20020025419, EP 1 182 244, US 5,683,823, US 5,503,910, US 5,405,709, and US 5,283,182 and can be equipped with a suitable filter arrangement to produce a color emission.

This invention may be used in so-called stacked device architecture, for example, as taught in US 5,703,436 and US 6,337,492.

### Deposition of Organic Layers

The organic materials mentioned above are suitably deposited through sublimation, but can be deposited from a solvent with an optional binder to improve film formation. If the material is a polymer, solvent deposition is usually preferred. The material to be deposited by sublimation can be vaporized from a sublimator "boat" often comprised of a tantalum material, e.g., as described in US 6,237,529, or can be first coated onto a donor sheet and then sublimed in closer proximity to the substrate. Layers with a mixture of materials can utilize separate sublimator boats or the materials can be pre-mixed and coated from a single boat or donor sheet. Patterned deposition can be achieved using shadow masks, integral shadow masks (US 5,294,870), spatially-defined thermal dye transfer from a donor sheet (US 5,851,709 and US 6,066,357) and inkjet method (US 6,066,357).

Organic materials useful in making OLEDs, for example organic hole-transporting materials, organic light-emitting materials doped with an organic electroluminescent components have relatively complex molecular structures with relatively weak molecular bonding forces, so that care must be taken to avoid decomposition of the organic material(s) during physical vapor deposition. The aforementioned organic materials are synthesized to a relatively high degree of purity, and are provided in the form of powders, flakes, or granules. Such powders or flakes have been used heretofore for placement into a physical vapor deposition source wherein heat is applied for forming a vapor by sublimation or vaporization of the organic material, the vapor condensing on a substrate to provide an organic layer thereon.

Several problems have been observed in using organic powders, flakes, or granules in physical vapor deposition: These powders, flakes, or granules are difficult to handle. These organic materials generally have a relatively low physical density and undesirably low thermal conductivity, particularly when placed in a physical vapor deposition source which is disposed in a chamber evacuated to a reduced pressure as low as 10⁻⁶ Torr. Consequently, powder particles, flakes, or granules are heated only by radiative heating from a heated source, and by conductive heating of particles or flakes directly in contact with heated surfaces of the source. Powder particles, flakes, or granules which are not in contact with heated surfaces of the source are not effectively heated by conductive heating due to a relatively low particle-to-particle contact area; This can lead to nonuniform heating of such organic materials in physical vapor deposition sources. Therefore, result in potentially nonuniform vapor-deposited organic layers formed on a substrate.

These organic powders can be consolidated into a solid pellet. These solid pellets consolidating into a solid pellet from a mixture of a sublimable organic material powder are easier to handle. Consolidation of organic powder into a solid pellet can be accomplished with relatively simple tools. A solid pellet formed from mixture comprising one or more non-luminescent organic non-electroluminescent component materials or luminescent electroluminescent component materials or mixture of non-electroluminescent component and electroluminescent component materials can be placed into a physical vapor deposition source for making organic layer. Such consolidated pellets can be used in a physical vapor deposition apparatus.

In one aspect, the present invention provides a method of making an organic layer from compacted pellets of organic materials on a substrate, which will form part of an OLED.

One preferred method for depositing the materials of the present invention is described in US 2004/0255857 and USSN 10/945,941 where different source evaporators are used to evaporate each of the materials of the present invention. A second preferred method involves the use of flash evaporation where materials are metered along a material feed path in which the material feed path is temperature controlled. Such a preferred method is described in the following coassigned patent applications: USSN 10/784,585; USSN 10/805,980; USSN 10/945,940; USSN 10/945,941; USSN 11/050,924; and USSN 11/050,934. Using this second method, each material may be evaporated using different source evaporators or the solid materials may be mixed prior to evaporation using the same source evaporator.

### Encapsulation

Most OLED devices are sensitive to moisture or oxygen, or both, so they are commonly sealed in an inert atmosphere such as nitrogen or argon, along with a desiccant such as alumina, bauxite, calcium sulfate, clays, silica gel, zeolites, alkaline metal oxides, alkaline earth metal oxides, sulfates, or metal halides and perchlorates. Methods for encapsulation and desiccation include, but are not limited to, those described in U.S. Patent No. 6,226,890. In addition, barrier layers such as SiOₓ, Teflon, and alternating inorganic/polymeric layers are known in the art for encapsulation. Any of these methods of sealing or encapsulation and desiccation can be used with the EL devices constructed according to the present invention.

### Optical Optimization

OLED devices of this invention can employ various well-known optical effects in order to enhance their emissive properties if desired. This includes optimizing layer thicknesses to yield maximum light transmission, providing dielectric mirror structures, replacing reflective electrodes with light-absorbing electrodes, providing anti-glare or anti-reflection coatings over the display, providing a polarizing medium over the display, or providing colored, neutral density, or color-conversion filters over the display. Filters, polarizers, and anti-glare or anti-reflection coatings may be specifically provided over the EL device or as part of the EL device.

Embodiments of the invention may provide advantageous features such as higher luminous yield, lower drive voltage, and higher power efficiency, longer operating lifetimes or ease of manufacture. Embodiments of devices useful in the invention can provide a wide range of hues including those useful in the emission of white light (directly or through filters to provide multicolor displays). Embodiments of the invention can also provide an area lighting device.

The invention and its advantages are further illustrated by the specific examples that follow.

### EXAMPLES

The following examples are directed to the invention claimed herein. The term "percentage" or "percent" and the symbol "%" indicate the volume percent (or a thickness ratio as measured on a thin film thickness monitor) of a particular first or second compound of the total material in the layer of the invention and other components of the devices. If more than one second compound is present, the total volume of the second compounds can also be expressed as a percentage of the total material in the layer of the invention.

### Example A: - Synthesis of Cpd-2.

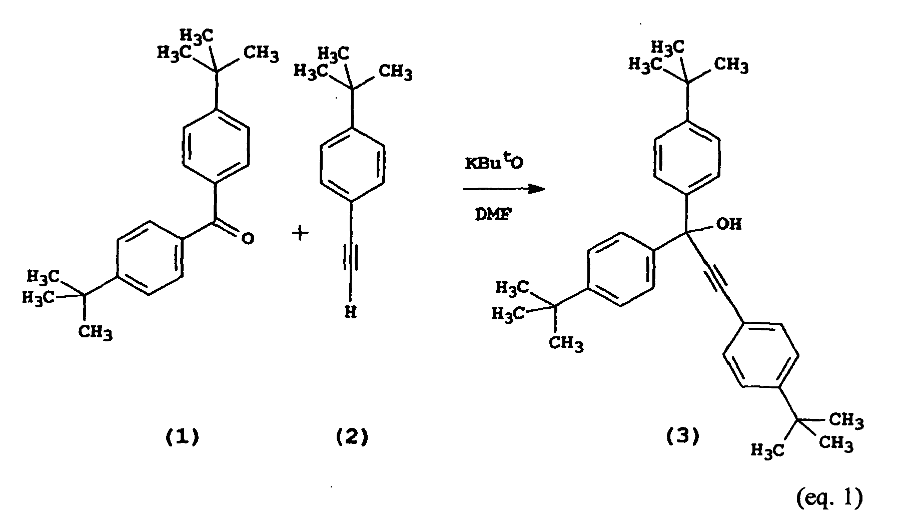

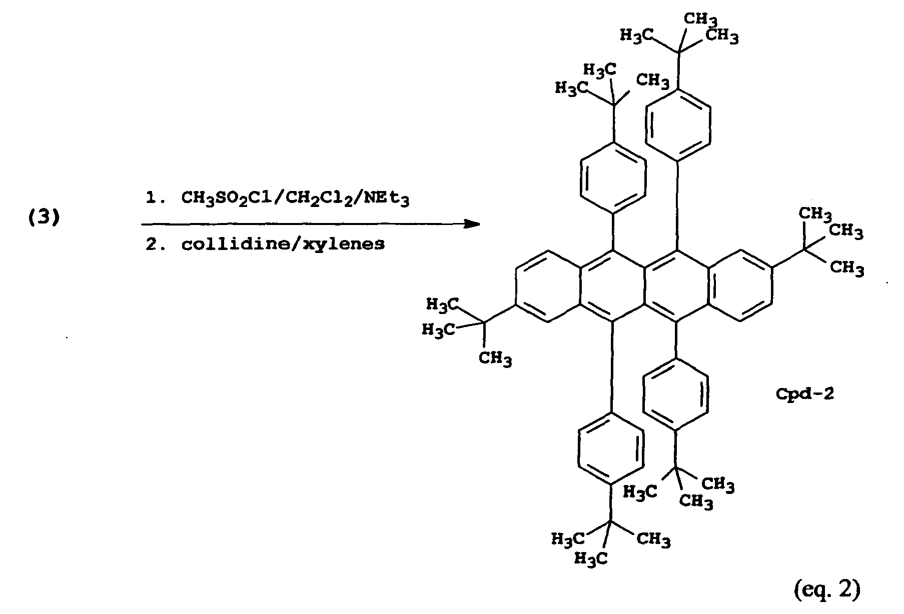

Compound (3), eq. 1, was prepared in the following manner. Under a nitrogen atmosphere, acetylenic compound (2) (2.0 g, 12 mMole), was dissolved in dimethylformamide (DMF) (100mL) and the solution cool to 0°C. Potassium t-butoxide (KBu^{t}O) (1.4 g, 12 mMole), was added and the mixture stirred well for approximately 15 minutes. To this mixture was then added the benzophenone (1) (3.53g, 30mMole). Stirring was continued at 0°C for approximately 30 minutes and then allowed to come to room temperature over a 1-hour period. At the end of this time the solution was cooled to 0°C and the reaction treated with saturated sodium chloride (20mL). The mixture was then diluted with ethyl acetate, washed with 2N-HCl (3 times), dried over MgSO₄, filtered and concentrated under reduced pressure. The crude product was triturated with petroleum ether to give the product as an off-white solid. The yield of compound (3) was 3.0 g.

Compound (3) (7.0 g, 15 mMole) was dissolved in methylene chloride (CH₂Cl₂) (70 mL), and stirred at 0°C under a nitrogen atmosphere. To this solution was added triethylamine (NEt₃) (1.56 g, 15 mMole) and then the mixture was treated drop by drop with methanesulfonyl chloride (CH₃SO₂Cl) (1.92 g, 15 mMole), keeping the temperature of the reaction in the range 0-5°C. After the addition, the solution was stirred at 0°C for 30 minutes, and then allowed to warm to room temperature over 1 hour. The reaction was then heated to reflux, distilling off the methylene chloride solvent. The methylene chloride solvent was gradually replaced by adding xylenes (a total of 70 mL). When the internal temperature of the reaction reached 80°C, collidine (2.40 g, 19.82 mMole), dissolved in xylenes (10 mL) was added drop by drop over a 10-minute period. The temperature was then raised to 110°C and held at this temperature for 4 hours. After this period the reaction was cooled and concentrated under reduced pressure. The oily residue was stirred with methanol (70 mL) to give the crude product. This material was filtered off, washed with methanol and petroleum ether to give compound Cpd-2 as a bright red solid. The yield was 1.5 g and Cpd-2 had a melting point of 300-305°C. The product may be further purified by sublimation (250°C @ 200 millitorr, 1 Torr = 133 Pa) with a N₂ carrier gas.

### Example B: - Synthesis of MC-1

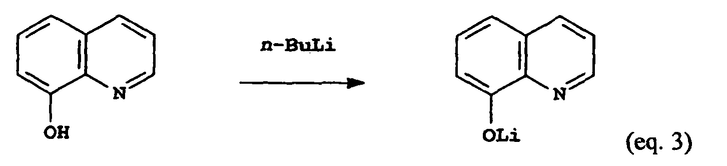

8-Hydroxyquinoline (4.64g, 31.96mMoles) was dissolved in acetonitrile (50mL). To this solution was added 2.5M n-BuLi (15.5mL, 36.36 mMoles) drop by drop at room temperature under a nitrogen atmosphere. After the addition of the n-BuLi, the mixture was stirred for 1 hour. The yellow solid was filtered off, washed with a little cold water, acetonitrile and finally air dried. The yield of lithium 8-quinolate (Liq) was 4.8g.

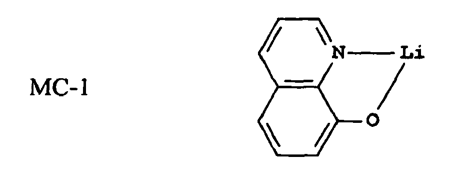

### Example 1: - Fabrication of Devices 1-1 through 1-6

A series of EL devices (1-1 through 1-6) were constructed in the following manner.
1. A glass substrate coated with an 85 nm layer of indium-tin oxide (ITO), as the anode, was sequentially ultrasonicated in a commercial detergent, rinsed in deionized water, degreased in toluene vapor and exposed to oxygen plasma for about 1 min.
2. Over the ITO was deposited a 1 nm fluorocarbon (CFx) hole-injecting layer (HIL1) by plasma-assisted deposition of CHF₃ as described in US 6,208,075.
3. Next a layer of hole-transporting material 4,4'-Bis[N-(1-naphthyl)-N-phenylamino]biphenyl (NPB) was deposited to a thickness of 75 nm.
4. A 35 nm light-emitting layer (LEL) of Alq₃ was then deposited.
5. A 35 nm electron-transporting layer (ETL) of Alq₃ or a mixture of Cpd-1 (rubrene) and MC-20, see Table 1, was vacuum-deposited over the LEL.
6. 0.5 nm layer of lithium fluoride was vacuum deposited onto the ETL, followed by a 150 nm layer of aluminum, to form a cathode layer.

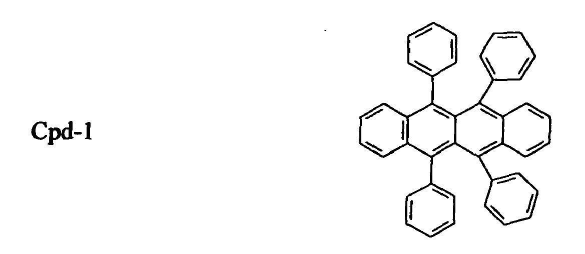

The above sequence completes the deposition of the EL device. The device is then hermetically packaged in a dry glove box for protection against ambient environment.

The devices thus formed were tested for drive voltage and luminous efficiency at an operating current of 20 mA/cm² and the results are reported in Table 1.

**Table 1. Device data for 1-1 through 1-6, Example 1.**

| Device | Example | % Alq₃ | % MC-20 | % Cpd-1 | Volt.¹ (V) | Luminance Efficiency (W/A) |
|---|---|---|---|---|---|---|
| 1-1 | Comparative | 100 | 0 | 0 | 7.2 | 0.020 |
| 1-2 | Inventive | | 100 | | 6.9 | 0.019 |
| 1-3 | Inventive | 0 | 10 | 90 | 5.9 | 0.019 |
| 1-4 | Inventive | 0 | 25 | 75 | 5.4 | 0.019 |
| 1-5 | Inventive | 0 | 50 | 50 | 5.6 | 0.019 |
| 1-6 | Inventive | 0 | 75 | 25 | 6.0 | 0.019 |

| | | | | | | |
|---|---|---|---|---|---|---|
| ¹The voltage needed to produce an operating current of 20 mA/cm² | | | | | | |

As illustrated in the inventive examples of Table 1, when the electron-transporting layer of a device consists of the metal complex MC-20 or mixed with carbocycle Cpd-1, one can obtain a reduction in the device voltage, while still maintaining good luminance efficiency compared to the comparison devices; example 1-1, Alq₃(100%).

### Example 2: - Fabrication of Devices 2-1 through 2-6

A series of EL devices (2-1 through 2-6) were constructed in the following manner.
1. A glass substrate coated with an 85 nm layer of indium-tin oxide (ITO), as the anode, was sequentially ultrasonicated in a commercial detergent, rinsed in deionized water, degreased in toluene vapor and exposed to oxygen plasma for about 1 min.
2. Over the ITO was deposited a 1 nm fluorocarbon (CFx) hole-injecting layer (HIL1) by plasma-assisted deposition of CHF₃ as described in US 6,208,075
3. Next a layer of hole-transporting material 4,4'-Bis[*N*-(1-naphthyl)-*N-*phenylamino]biphenyl (NPB) was deposited to a thickness of 75 nm.
4. A 20 nm light-emitting layer (LEL) of Cpd-12 with 1.5 volume % of blue dopant L55 was then deposited.
5. 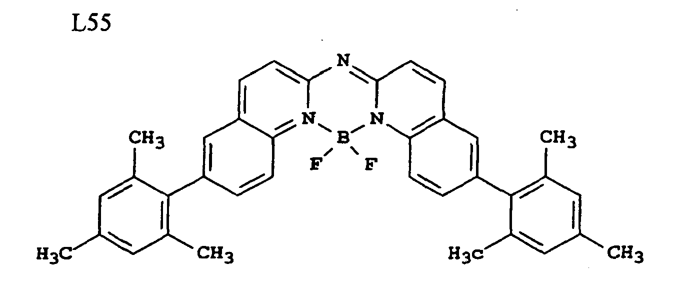
6. A 35 nm electron-transporting layer (ETL) of Alq₃ or a mixture of MC-20 and Cpd-12, see Table 2, was vacuum-deposited over the LEL.
7. 0.5 nm layer of lithium fluoride was vacuum deposited onto the ETL, followed by a 150 nm layer of aluminum, to form a cathode layer.

The above sequence completes the deposition of the EL device. The device is then hermetically packaged in a dry glove box for protection against ambient environment.

The devices thus formed were tested for drive voltage and luminous efficiency at an operating current of 20 mA/cm² and the results are reported in Table 2.

**Table 2. Device data for 2-1 through 2-6, Example 2.**

| Device | Example | % Alq₃ | % MC-20 | % Cpd-12 | Volt.¹ (V) | Luminance Efficiency (W/A) | CIE x/y | |
|---|---|---|---|---|---|---|---|---|
| 2-1 | Comparative | 100 | 0 | 0 | 6.5 | 0.051 | 0.160 | 0.171 |
| 2-2 | Inventive | 0 | 100 | 0 | 6.4 | 0.048 | 0.145 | 0.134 |
| 2-3 | Inventive | 0 | 90 | 10 | 6.7 | 0.047 | 0.145 | 0.134 |
| 2-4 | Inventive | 0 | 75 | 25 | 5.5 | 0.079 | 0.145 | 0.137 |
| 2-5 | Inventive | 0 | 50 | 50 | 5.1 | 0.103 | 0.145 | 0.139 |
| 2-6 | Inventive | 0 | 25 | 75 | 5.8 | 0.091 | 0.145 | 0.139 |

| | | | | | | | | |
|---|---|---|---|---|---|---|---|---|
| ¹The voltage needed to produce an operating current of 20 mA/cm² | | | | | | | | |

As illustrated in the inventive examples of Table 2, when the electron-transporting layer of a device consists of the metal complex MC-20 or mixed with carbocycle Cpd-12, one can obtain a device voltage similar or lower to comparison 2-1. However, the luminance efficiency and CIE color coordinates of the examples of the invention are excellent when compared to the comparison devices.

### Example 3: - Fabrication of Devices 3-1 through 3-6

A series of EL devices (3-1 through 3-6) was constructed in an identical manner as described for Example 1, except that the carbocycle Cpd-1, was replaced with Cpd-12.

The devices thus formed were tested for drive voltage and luminous efficiency at an operating current of 20 mA/cm² and the results are reported in Table 3.

**Table 3. Device data for 3-1 through 3-6, Example 3.**

| Device | Example | % Alq₃ | % MC-20 | % Cpd-12 | Volt.¹ (V) | Luminance Efficiency (W/A) | CIE x/y | |
|---|---|---|---|---|---|---|---|---|
| 3-1 | Comparative | 100 | 0 | 0 | 6.8 | 0.021 | 0.333 | 0.550 |
| 3-2 | Inventive | 0 | 100 | 0 | 6.3 | 0.020 | 0.329 | 0.544 |
| 3-3 | Inventive | 0 | 10 | 90 | 7.9 | 0.021 | 0.325 | 0.548 |
| 3-4 | Inventive | 0 | 25 | 75 | 8.4 | 0.020 | 0.346 | 0.555 |
| 3-5 | Inventive | 0 | 50 | 50 | 5.1 | 0.021 | 0.336 | 0.547 |
| 3-6 | Inventive | 0 | 75 | 25 | 5.6 | 0.021 | 0.330 | 0.546 |

| | | | | | | | | |
|---|---|---|---|---|---|---|---|---|
| ¹The voltage needed to produce an operating current of 20 mA/cm² | | | | | | | | |

As illustrated in the inventive examples of Table 3, when the electron-transporting layer of a device consists of the metal complex MC-20 or mixed with carbocycle Cpd-12, on average, one can obtain a device voltage similar to or lower than comparison 3-1 with similar luminance efficiency and CIE color coordinates of the examples of the invention.

### Comparative 4: - Fabrication of Devices 4-1 through 4-5

A series of EL devices (4-1 through 4-5) was constructed in an identical manner as described for Example 1, except that the metal complex MC-20 in the ETL was replaced with comparative MC-28.

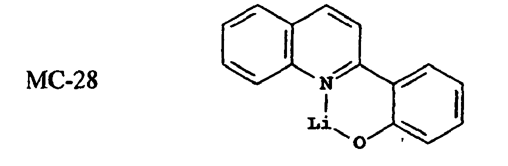

The devices thus formed were tested for drive voltage and luminous efficiency at an operating current of 20 mA/cm² and the results are reported in Table 4.

**Table 4. Device data for 4-1 through 4-5, Example 4.**

| Device | Example | % MC-28 | % Cpd-1 | Volt.¹ (V) | Luminance Efficiency (W/A) | CIE x/y | |
|---|---|---|---|---|---|---|---|
| 4-1 | Comparative | 100 | 0 | 9.8 | 0.014 | 0.330 | 0.541 |
| 4-2 | Comparative | 90 | 10 | 9.9 | 0.011 | 0.390 | 0.527 |
| 4-3 | Comparative | 75 | 25 | 6.2 | 0.020 | 0.341 | 0.542 |
| 4-4 | Comparative | 50 | 50 | 5.0 | 0.020 | 0.339 | 0.542 |
| 4-5 | Comparative | 25 | 75 | 5.0 | 0.019 | 0.334 | 0.541 |

| | | | | | | | |
|---|---|---|---|---|---|---|---|
| ¹The voltage needed to produce an operating current of 20 mA/cm² | | | | | | | |

As illustrated in the examples of Table 4, when the electron-transporting layer of a device consists of the metal complex MC-28 or mixed with carbocycle Cpd-1, generally the combination of voltage, luminance efficiency and CIE color coordinates was inferior to that of the examples of the invention in Example 1.

### Comparative Example 5

### Fabrication of Devices 5-1 through 5-5

A series of EL devices (5-1 through 5-5) was constructed in an identical manner as described for Example 1, except that the metal complex MC-20 in the ETL was replaced with comparative MC-30.

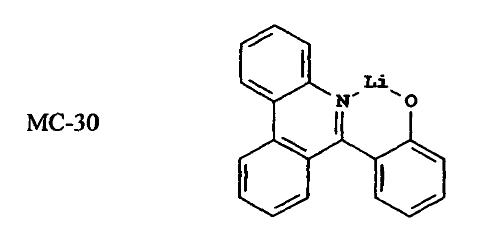

The devices thus formed were tested for drive voltage and luminous efficiency at an operating current of 20 mA/cm² and the results are reported in Table 5.

**Table 5. Device data for 5-1 through 5-5, Example 5.**

| Device | Example | % MC-30 | % Cpd-1 | volt.¹ (V) | Luminance Efficiency (W/A) | CIE x/y | |
|---|---|---|---|---|---|---|---|
| 5-1 | Comparative | 100 | 0 | 8.8 | 0.016 | 0.325 | 0.543 |
| 5-2 | Comparative | 90 | 10 | 8.8 | 0.013 | 0.355 | 0.535 |
| 5-3 | Comparative | 75 | 25 | 6.7 | 0.017 | 0.337 | 0.542 |
| 5-4 | Comparative | 50 | 50 | 5.7 | 0.018 | 0.332 | 0.544 |
| 5-5 | Comparative | 25 | 75 | 5.6 | 0.017 | 0.333 | 0.542 |

| | | | | | | | |
|---|---|---|---|---|---|---|---|
| ¹ The voltage needed to produce an operating current of 20 mA/cm² | | | | | | | |

As illustrated in the examples of Table 5, on average, when the electron-transporting layer of a device consists of the metal complex MC-30 or mixed with carbocycle Cpd-1, the combination of voltage, luminance efficiency and CIE color coordinates was inferior to that of the examples of the invention in Example 1.

### Example 6: - Fabrication of Devices 6-1 through 6-12

A series of EL devices (6-1 through 6-12) were constructed in the following manner.
1. A glass substrate coated with an 85 nm layer of indium-tin oxide (ITO), as the anode, was sequentially ultrasonicated in a commercial detergent, rinsed in deionized water, degreased in toluene vapor and exposed to oxygen plasma for about 1 min.
2. Over the ITO was deposited a 1 nm fluorocarbon (CFx) hole-injecting layer (HIL1) by plasma-assisted deposition of CHF₃ as described in US 6,208,075.
3. A hole-injecting layer (HIL2) of dipyrazino[2,3-f:2',3'-h]quinoxalinehexacarbonitrile was deposited to a thickness of 10 nm.
4. Next a layer of hole-transporting material 4,4'-Bis[*N*-(1-naphthyl)-*N-*phenylamino]biphenyl (NPB) was deposited to a thickness of 100 nm.
5. A 40 nm light-emitting layer (LEL) of red dopant, L22 (2 volume %) in Cpd-12 was then deposited.
6. An electron-transporting layer (ETL) of Alq₃, Cpd-12, a mixture of Cpd-12 and MC-1, or MC-1 alone, see Table 6, was vacuum-deposited over the LEL.
7. An electron-injection layer (EIL) of 3.5 nm of MC-20 or 0.5 nm lithium fluoride, see Table 6, was vacuum deposited onto the ETL, followed by a 100 nm layer of aluminum, to form a cathode layer.

The total thickness of the ETL and EIL layers was 35.5 nm. So when the EIL was MC-20 (3.5 nm) the ETL had a thickness of 32.0 nm, when the EIL was lithium fluoride, the ETL had a thickness of 35.0 nm.

The above sequence completes the deposition of the EL device. The device is then hermetically packaged in a dry glove box for protection against ambient environment.

The devices thus formed were tested for drive voltage and luminous efficiency at an operating current of 20 mA/cm² and the results are reported in Table 6.

**Table 6. Device data for 6-1 through 6-12, Example 6.**

| Device | Example | % Alq₃ | % Cpd-12 | % MC-1 | EIL | Volt.¹ (V) | Luminance Efficiency (W/A) | CIE x/y | |
|---|---|---|---|---|---|---|---|---|---|
| 6-1 | Inventive | 100 | 0 | 0 | MC-20 | 8.2 | 0.080 | 0.277 | 0.620 |
| 6-2 | Comparative | 100 | 0 | 0 | LiF | 8.6 | 0.072 | 0.278 | 0.619 |
| 6-3 | Comparative | 100 | 0 | 0 | - | 10.5 | 0.022 | 0.285 | 0.615 |
| 6-4 | Inventive | 0 | 100 | 0 | MC-20 | 5.1 | 0.104 | 0.300 | 0.617 |
| 6-5 | Comparative | 0 | 100 | 0 | LiF | 12.0 | 0.001 | 0.316 | 0.609 |
| 6-6 | Comparative | 0 | 100 | 0 | - | 11.3 | 0.0003 | 0.314 | 0.611 |
| 6-7 | Inventive | 0 | 50 | 50 | MC-20 | 5.2 | 0.119 | 0.292 | 0.617 |
| 6-8 | Comparative | 0 | 50 | 50 | LiF | 6.9 | 0.103 | 0.293 | 0.616 |
| 6-9 | Comparative | 0 | 50 | 50 | - | 7.8 | 0.097 | 0.284 | 0.619 |
| 6-10 | Inventive | 0 | 0 | 100 | MC-20 | 11.2 | 0.081 | 0.267 | 0.614 |
| 6-11 | Comparative | 0 | 0 | 100 | LiF | 11.9 | 0.072 | 0.271 | 0.613 |
| 6-12 | Comparative | 0 | 0 | 100 | - | 12.2 | 0.075 | 0.270 | 0.613 |

| | | | | | | | | | |
|---|---|---|---|---|---|---|---|---|---|
| ¹ The voltage needed to produce an operating current of 20 mA/cm² | | | | | | | | | |

As illustrated in the inventive examples of Table 6, when the electron-injecting layer of a device comprises the metal complex MC-20, one obtains improved drive voltage with increased luminance efficiency compared to the comparison devices. Inventive example 6-7, with a mixture of Cpd-12 and MC-1 in the electron-transporting layer, shows even more improvement in the drive voltage and increased luminance efficiency, while not suffering any color change as shown in example 6-4.

### Example 7: - Fabrication of Devices 7-1 through 7-10

A series of EL devices (7-1 through 7-10) were constructed in the following manner.
1. A glass substrate coated with an 85 nm layer of indium-tin oxide (ITO), as the anode, was sequentially ultrasonicated in a commercial detergent, rinsed in deionized water, degreased in toluene vapor and exposed to oxygen plasma for about 1 min.
2. Over the ITO was deposited a 1 nm fluorocarbon (CFx) hole-injecting layer (HIL1) by plasma-assisted deposition of CHF3 as described in US 6,208,075.
3. A hole-injecting layer (HIL2) of dipyrazino[2,3-f:2',3'-h]quinoxalinehexacarbonitrile was deposited to a thickness of 10 nm.
4. Next a layer of hole-transporting material 4,4'-Bis[N-(1-naphthyl)-N-phenylamino]biphenyl (NPB) was deposited to a thickness of 85 nm.
5. A 20 nm light-emitting layer (LEL) of blue dopant, L55 (1.5 volume %) in Cpd-12 was then deposited.
6. An electron-transporting layer (ETL) of Alq₃, Cpd-12, a mixture of Cpd-12 and MC-1, MC-1 alone, a mixture of Cpd-12 and MC-20, or MC-20 alone, see Table 27, was vacuum-deposited over the LEL. Device 7-1 contained only Alq₃ in the ETL.
7. An electron-injection layer (EIL) of 3.5 nm of MC-20 or 0.5 nm lithium fluoride, see Table 7, was vacuum deposited onto the ETL, followed by a 100 nm layer of aluminum, to form a cathode layer.

The total thickness of the ETL and EIL layers was 35.5 nm. So when the EIL was MC-20 (3.5 nm) the ETL had a thickness of 32.0 nm, when the EIL was lithium fluoride, the ETL had a thickness of 35.0 nm.

The above sequence completes the deposition of the EL device. The device is then hermetically packaged in a dry glove box for protection against ambient environment.

The devices thus formed were tested for drive voltage and luminous efficiency at an operating current of 20 mA/cm² and the results are reported in Table 7.

**Table 7. Device data for 7-1 through 7-12, Example 7.**

| Device | Example | % Cpd-12 | % MC-1 | % MC-20 | EIL | Volt.¹ (V) | Luminance Efficiency (W/A) | CIE x/y | |
|---|---|---|---|---|---|---|---|---|---|
| 7-1 | Inventive | 0 | 0 | 0 | MC-20 | 6.3 | 0.061 | 0.158 | 0.183 |
| 7-2 | Inventive | 100 | 0 | 0 | MC-20 | 4.7 | 0.116 | 0.144 | 0.162 |
| 7-3 | Inventive | 50 | 0 | 50 | MC-20 | 4.7 | 0.125 | 0.144 | 0.144 |
| 7-4 | Inventive | 50 | 0 | 50 | LiF | 5.3 | 0.104 | 0.143 | 0.144 |
| 7-5 | Inventive | 50 | 0 | 50 | - | 6.4 | 0.075 | 0.143 | 0.143 |
| 7-6 | Inventive | 0 | 0 | 100 | MC-20 | 6.3 | 0.058 | 0.143 | 0.133 |
| 7-7 | Inventive | 50 | 50 | 0 | MC-20 | 4.6 | 0.142 | 0.144 | 0.146 |
| 7-8 | Comparative | 50 | 50 | 0 | LiF | 6.0 | 0.111 | 0.142 | 0.139 |
| 7-9 | Comparative | 50 | 50 | 0 | - | 6.4 | 0.104 | 0.142 | 0.139 |
| 7-10 | Inventive | 0 | 100 | 0 | MC-20 | 8.8 | 0.065 | 0.144 | 0.138 |

| | | | | | | | | | |
|---|---|---|---|---|---|---|---|---|---|
| ¹ The voltage needed to produce an operating current of 20 mA/cm² | | | | | | | | | |

As illustrated in the inventive examples of Table 7, when the electron-injecting layer or electron-transporting layer of a device comprises metal complex MC-20, one obtains improved drive voltage with increased luminance efficiency compared to the comparison devices. Inventive examples 7-3 and 7-7, with a mixture of Cpd-12 and MC-20 or MC-1 respectively in the electron-transporting layer, shows even more improvement in the drive voltage and increased luminance efficiency.

### Example 8: - Fabrication of Devices 8-1 through 8-12

A series of EL devices (8-1 through 8-12) were constructed in the following manner.
1. A glass substrate coated with an 85 nm layer of indium-tin oxide (ITO), as the anode, was sequentially ultrasonicated in a commercial detergent, rinsed in deionized water, degreased in toluene vapor and exposed to oxygen plasma for about 1 min.
2. Over the ITO was deposited a 1 nm fluorocarbon (CFx) hole-injecting layer (HIL1) by plasma-assisted deposition of CHF₃ as described in US 6,208,075.
3. A hole-injecting layer (HIL2) of dipyrazino[2,3-f:2',3'-h]quinoxalinehexacarbonitrile was deposited to a thickness of 10 nm.
4. Next a layer of hole-transporting material 4,4'-Bis[*N*-(1-naphthyl)-*N-*phenylamino]biphenyl (NPB) was deposited to a thickness of 85 nm.
5. A 20 nm light-emitting layer (LEL) of blue dopant, L55 (1.5 volume %) in Cpd-12 was then deposited.
6. An electron-transporting layer (ETL) of Alq₃, Cpd-12, a mixture of Cpd-12 and MC-1, or MC-1 alone, see Table 8, was vacuum-deposited over the LEL.
7. An electron-injection layer (EIL) of 3.5 nm of MC-20 or 0.5 nm lithium fluoride, see Table 8, was vacuum deposited onto the ETL, followed by a 100 nm layer of aluminum, to form a cathode layer.

The total thickness of the ETL and EIL layers was 35.5 nm. So when the EIL was MC-20 (3.5 nm) the ETL had a thickness of 32.0 nm, when the EIL was lithium fluoride, the ETL had a thickness of 35.0 nm.

The above sequence completes the deposition of the EL device. The device is then hermetically packaged in a dry glove box for protection against ambient environment.

The devices thus formed were tested for drive voltage and luminous efficiency at an operating current of 20 mA/cm² and the results are reported in Table 8.

**Table 8. Device data for 8-1 through 8-12, Example 8.**

| Device | Example | % Alq₃ | % Cpd-12 | % MC-1 | EIL | Volt.¹ (V) | Luminance Efficiency (W/A) | CIE x/y | |
|---|---|---|---|---|---|---|---|---|---|
| 8-1 | Inventive | 100 | 0 | 0 | MC-20 | 6.4 | 0.068 | 0.155 | 0.177 |
| 8-2 | Comparative | 100 | 0 | 0 | LiF | 6.5 | 0.061 | 0.156 | 0.182 |
| 8-3 | Comparative | 100 | 0 | 0 | - | 8.5 | 0.018 | 0.161 | 0.195 |
| 8-4 | Inventive | 0 | 100 | 0 | MC-20 | 4.7 | 0.133 | 0.144 | 0.157 |
| 8-5 | Comparative | 0 | 100 | 0 | LiF | 9.2 | 0.0017 | 0.139 | 0.148 |
| 8-6 | Comparative | 0 | 100 | 0 | - | 9.0 | 0.0004 | 0.139 | 0.147 |
| 8-7 | Inventive | 0 | 50 | 50 | MC-20 | 4.7 | 0.148 | 0.142 | 0.143 |
| 8-8 | Comparative | 0 | 50 | 50 | LiF | 6.0 | 0.166 | 0.142 | 0.141 |
| 8-9 | Comparative | 0 | 50 | 50 | - | 6.6 | 0.103 | 0.142 | 0.140 |
| 8-10 | Inventive | 0 | 0 | 100 | MC-20 | 8.9 | 0.070 | 0.144 | 0.144 |
| 8-11 | Comparative | 0 | 0 | 100 | LiF | 9.6 | 0.065 | 0.144 | 0.145 |
| 8-12 | Comparative | 0 | 0 | 100 | - | 9.7 | 0.064 | 0.143 | 0.144 |

| | | | | | | | | | |
|---|---|---|---|---|---|---|---|---|---|
| ¹ The voltage needed to produce an operating current of 20 mA/cm² | | | | | | | | | |

As illustrated in the inventive examples of Table 8, when the electron-injecting layer or electron-transporting layer of a device comprises metal complex MC-20, one obtains improved drive voltage with increased luminance efficiency compared to the comparison devices. Inventive example 8-7, with a mixture of Cpd-12 and MC-1 in the electron-transporting layer, shows even more improvement in the drive voltage and increased luminance efficiency, without the color shift shown in example 8-4.

### Example 9: - Fabrication of Devices 9-1 through 9-12

A series of EL devices (9-1 through 9-12) were constructed in the following manner.
1. A glass substrate coated with an 85 nm layer of indium-tin oxide (ITO), as the anode, was sequentially ultrasonicated in a commercial detergent, rinsed in deionized water, degreased in toluene vapor and exposed to oxygen plasma for about 1 min.
2. Over the ITO was deposited a 1 nm fluorocarbon (CFx) hole-injecting layer (HIL1) by plasma-assisted deposition of CHF₃ as described in US 6,208,075.
3. A hole-injecting layer (HIL2) of dipyrazino[2,3-f:2',3'-h]quinoxalinehexacarbonitrile was deposited to a thickness of 10 nm.
4. Next a layer of hole-transporting material 4,4'-Bis[*N*-(1-naphthyl)-*N-*phenylamino]biphenyl (NPB) was deposited to a thickness of 134 nm.
5. A 20 nm light-emitting layer (LEL) of dopant, L46 (1.5 volume %) in L5 was then deposited.
6. An electron-transporting layer (ETL) of Alq₃, Cpd-12, a mixture of Cpd-12 and MC-1, or a mixture of Cpd-12 and MC-20, see Table 9, was vacuum-deposited over the LEL.
7. An electron-injection layer (EIL) of 3.5 nm of MC-20 or 0.5 nm lithium fluoride, see Table 9, was vacuum deposited onto the ETL, followed by a 100 nm layer of aluminum, to form a cathode layer.

The total thickness of the ETL and EIL layers was 40 nm. So when the EIL was MC-20 (3.5 nm) the ETL had a thickness of 36.5 nm, when the EIL was lithium fluoride, the ETL had a thickness of 39.5 nm.

The above sequence completes the deposition of the EL device. The device is then hermetically packaged in a dry glove box for protection against ambient environment.

The devices thus formed were tested for drive voltage and luminous efficiency at an operating current of 20 mA/cm² and the results are reported in Table 9.

**Table 9. Device data for 9-1 through 9-12, Example 9.**

| Device | Example | % Alq₃ | % Cpd-12 | % MC-1 | % MC-20 | EIL | Volt.¹ (V) | Luminance Efficiency (W/A) | CIE x/y | |
|---|---|---|---|---|---|---|---|---|---|---|
| 9-1 | Inventive | 100 | 0 | 0 | 0 | MC-20 | 5.5 | 0.063 | 0.646 | 0.349 |
| 9-2 | Comparative | 100 | 0 | 0 | 0 | LiF | 5.8 | 0.059 | 0.645 | 0.350 |
| 9-3 | Comparative | 100 | 0 | 0 | 0 | - | 7.4 | 0.020 | 0.628 | 0.362 |
| 9-4 | Inventive | 0 | 100 | 0 | 0 | MC-20 | 5.6 | 0.082 | 0.658 | 0.341 |
| 9-5 | Comparative | 0 | 100 | 0 | 0 | LiF | 6.1 | 0.0008 | 0.652 | 0.342 |
| 9-6 | Comparative | 0 | 100 | 0 | 0 | - | 5.8 | 0.0001 | 0.648 | 0.342 |
| 9-7 | Inventive | 0 | 50 | 50 | 0 | MC-20 | 5.0 | 0.153 | 0.659 | 0.340 |
| 9-8 | Comparative | 0 | 50 | 50 | 0 | LiF | 5.8 | 0.149 | 0.659 | 0.340 |
| 9-9 | Comparative | 0 | 50 | 50 | 0 | - | 6.1 | 0.142 | 0.659 | 0.340 |
| 9-10 | Inventive | 0 | 50 | 0 | 50 | MC-20 | 4.8 | 0.114 | 0.659 | 0.343 |
| 9-11 | Inventive | 0 | 50 | 0 | 50 | LiF | 5.3 | 0.083 | 0.651 | 0.346 |
| 9-12 | Inventive | 0 | 50 | 0 | 50 | - | 5.7 | 0.049 | 0.650 | 0.347 |

| | | | | | | | | | | |
|---|---|---|---|---|---|---|---|---|---|---|
| ¹ The voltage needed to produce an operating current of 20 mA/cm² | | | | | | | | | | |

As illustrated in the inventive examples of Table 9, when the electron-injecting layer of a device comprises metal complex MC-20, one obtains improved drive voltage with increased luminance efficiency compared to the comparison devices. Inventive example 9-7 and 9-10, with a mixture of Cpd-12 and MC-1 or MC-20 respectively in the electron-transporting layer, show even more improvement in the drive voltage and increased luminance efficiency.

### Example 10: - Fabrication of Devices 10-1 through 10-4

A series of EL devices (10-1 through 10-4) were constructed in the following manner.
1. A glass substrate coated with an 20 nm layer of indium-tin oxide (ITO), as the anode, was sequentially ultrasonicated in a commercial detergent, rinsed in deionized water, degreased in toluene vapor and exposed to oxygen plasma for about 1 min.
2. Over the ITO was deposited a 1 nm fluorocarbon (CFx) hole-injecting layer (HIL1) by plasma-assisted deposition of CHF₃ as described in US 6,208,075.
3. A hole-injecting layer (HIL2) of dipyrazino[2,3-f:2',3'-h]quinoxalinehexacarbonitrile was deposited to a thickness of 10 nm.
4. Next a layer of hole-transporting material 4,4'-Bis[*N*-(1-naphthyl)-*N-*phenylamino]biphenyl (NPB) was deposited to a thickness of 134 nm.
5. A light-emitting layer (LEL) was then deposited, see Table 31 for which LEL was used. The red LEL was 40 nm thick of red dopant, L46 (0.5 volume %) in L5. The blue LEL was 20 nm thick blue dopant, L55 (1.5 volume %) in Cpd-12.
6. An electron-transporting layer (ETL) of Cpd-12 and MC-1 as a 50/50 mixture by volume, was vacuum-deposited over the LEL.
7. An electron-injection layer (EIL) of MC-20 was vacuum deposited onto the ETL, followed by a 100 nm layer of aluminum, to form a cathode layer. The amount of MC-20 is shown in Table 10.

The total thickness of the ETL and EIL layers was 35 nm. So when the EIL was MC-20 (3.5 nm) the ETL had a thickness of 31.5 nm.

The above sequence completes the deposition of the EL device. The device is then hermetically packaged in a dry glove box for protection against ambient environment.

The devices thus formed were tested for drive voltage and luminous efficiency at an operating current of 20 mA/cm² and the results are reported in Table 10.

**Table 10. Device data for 10-1 through 10-4, Example 10.**

| Device | Example | color | EIL thickness | Volt.¹ (V) | Luminance Efficiency (W/A) | CIE x/y | |
|---|---|---|---|---|---|---|---|
| 10-1 | Comparative | red | 0 | 4.5 | 0.12 | 0.66 | 0.34 |
| 10-2 | Inventive | red | 3.5 | 3.6 | 0.135 | 0.66 | 0.34 |
| 10-3 | Comparative | blue | 0 | 6.5 | 0.11 | 0.14 | 0.13 |
| 10-4 | Inventive | blue | 3.5 | 3.4 | 0.17 | 0.14 | 0.13 |

| | | | | | | | |
|---|---|---|---|---|---|---|---|
| ¹ The voltage needed to produce an operating current of 20 mA/cm² | | | | | | | |

As illustrated in the inventive examples of Table 10, when the electron-injecting layer of a device comprises metal complex MC-20 and an anthracene, one obtains improved drive voltage with increased luminance efficiency compared to the comparison devices.

### Example 11: - Fabrication of Devices 11-1 through 11-4

A series of EL devices (11-1 through 11-4) were constructed in the following manner.
1. A glass substrate coated with an 20 nm layer of indium-tin oxide (ITO), as the anode, was sequentially ultrasonicated in a commercial detergent, rinsed in deionized water, degreased in toluene vapor and exposed to oxygen plasma for about 1 min.
2. Over the ITO was deposited a 1 nm fluorocarbon (CFx) hole-injecting layer (HIL1) by plasma-assisted deposition of CHF₃ as described in US 6,208,075.
3. A hole-injecting layer (HIL2) of dipyrazino[2,3-f:2',3'-h]quinoxalinehexacarbonitrile was deposited to a thickness of 10 nm.
4. A light-emitting layer (LEL) of Cpd-9 (30 volume %), and Cpd-3 (2 volume %) in 4,4'-Bis[*N*-(1-naphthyl)-*N*-phenylamino]biphenyl (NPB) was deposited to a thickness of 20 nm.
5. A second light-emitting layer (LEL) of L55 (1.5 volume %) in Cpd-12 was deposited to a thickness of 20 nm.
6. An electron-transporting layer (ETL) of Cpd-12, Bphen, or Alq₃, and MC-20, see Table 11, as a 50/50 mixture by volume, was vacuum-deposited over the LEL to a thickness of 31.5 nm.
7. An electron-injection layer (EIL) of MC-20 was vacuum deposited onto the ETL to a thickness of 35 nm.

The above sequence completes the deposition of the EL device. The device is then hermetically packaged in a dry glove box for protection against ambient environment.

The devices thus formed were tested for drive voltage and luminous efficiency at an operating current of 20 mA/cm² and the results are reported in Table 11.

**Table 11. Device data for 11-1 through 11-4, Example 11.**

| Device | Example | ETL | Volt.¹ (V) | Luminance Efficiency (W/A) | CIE x/y | |
|---|---|---|---|---|---|---|
| 11-1 | Inventive | Cpd-12/ MC-20 | 3.5 | 0.11 | 0.41 | 0.39 |
| 11-2 | Inventive | Bphen/ MC-20 | 4.7 | 0.06 | 0.4 | 0.38 |
| 11-3 | Inventive | Alq₃/ MC-20 | 5.2 | 0.06 | 0.39 | 0.39 |

| | | | | | | |
|---|---|---|---|---|---|---|
| ¹ The voltage needed to produce an operating current of 20 mA/cm² | | | | | | |

As illustrated in the inventive examples of Table 11, when the electron-injecting layer of a device comprises metal complex MC-20, one obtains improved drive voltage with increased luminance efficiency compared to the comparison devices. Examples 11-1 and 11-2, with the electron-transporting layer additionally comprising a fused ring aromatic compound show even more improvement in the drive voltage and increased luminance efficiency.

### Example 12 (Comparative)

The preparation of a conventional OLED is as follows: A ~1.1 mm thick glass substrate coated with a transparent ITO conductive layer was cleaned and dried using a commercial glass scrubber tool. The thickness of ITO is about 25 nm and the sheet resistance of the ITO is about 70 Ω/square. The ITO surface was subsequently treated with oxidative plasma to condition the surface as an anode. A layer of CFx, 1 nm thick, was deposited on the clean ITO surface as the anode buffer layer by decomposing CHF₃ gas in an RF plasma treatment chamber. The substrate was then transferred into a vacuum deposition chamber for deposition of all other layers on top of the substrate. The following layers were deposited in the following sequence by evaporation from a heated boat under a vacuum of approximately 10⁻⁶ Torr:
1. EL unit:
   a) an HIL, 10 nm thick, including Dpq-1
   b) an HTL, 100 nm thick, including NPB;
   c) an LEL, 40 nm thick, including Cpd-12 doped with 2.0 vol% L22;
   d) an ETL, 25 nm thick, including Cpd-12;
   e) an EIL, 1 nm thick, including MC-1; and
2. Cathode: approximately 120 nm thick, including Al.

After the deposition of these layers, the device was transferred from the deposition chamber into a dry box (made by VAC Vacuum Atmosphere Company, Hawthorne, CA) for encapsulation. The OLED has an emission area of 10 mm².

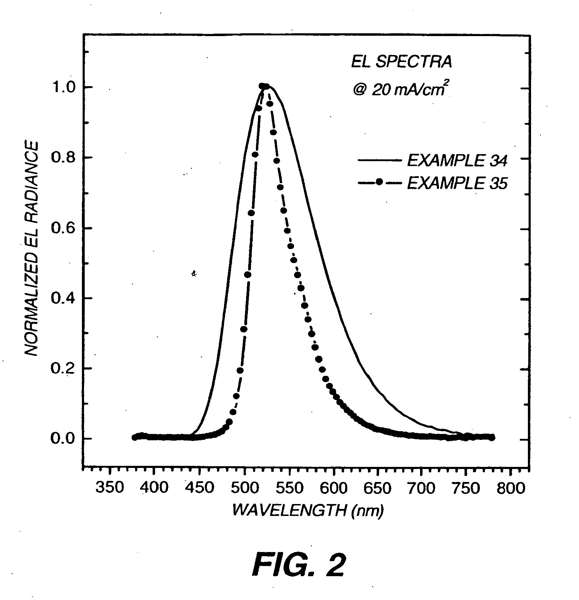

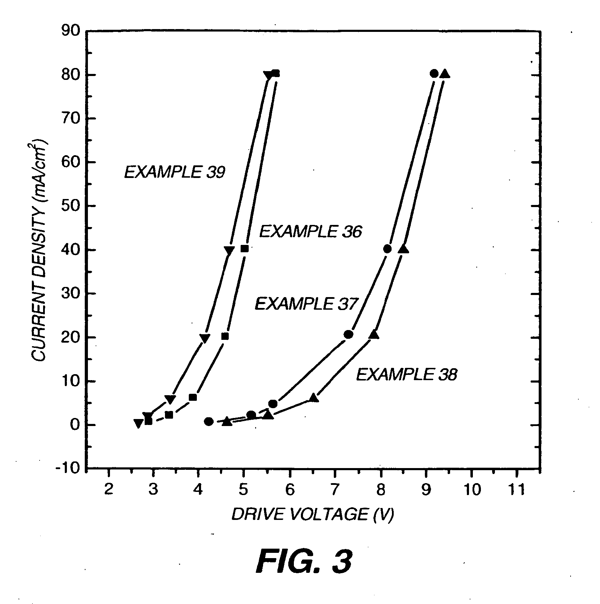

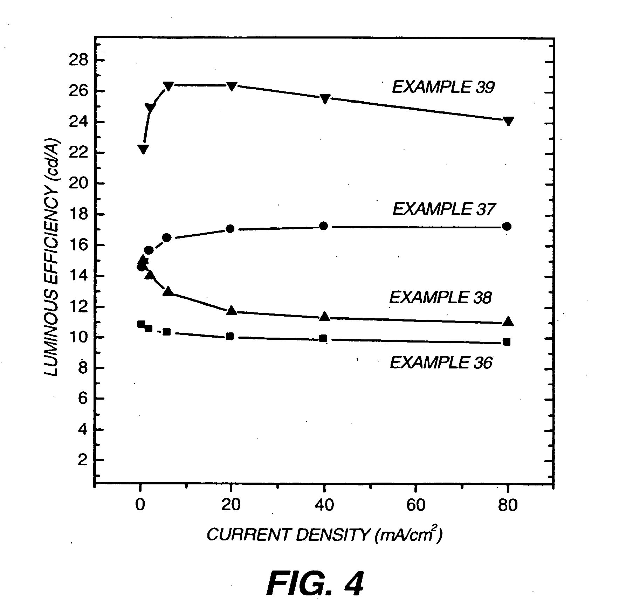

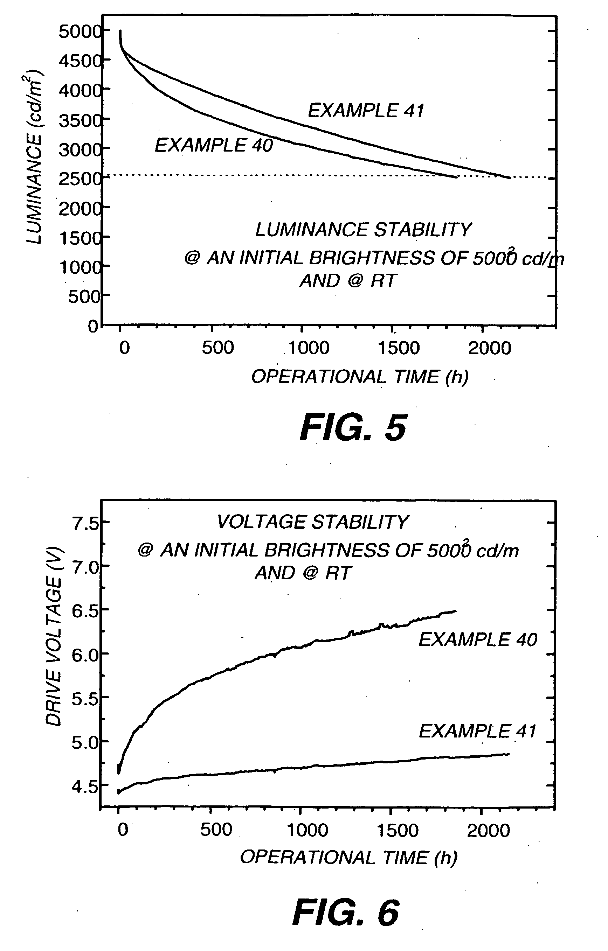

This OLED requires a drive voltage of about 3.6 V to pass 20 mA/cm². Under this test condition, the device has a luminance of 4,451 cd/m², and a luminous efficiency of about 22.8 cd/A. The color coordinates are CIEₓ = 0.233 and CIE_{y} = 0.626, and the emission peak is at 504 nm. The T₅₀(@5,000 nit) is 1,854 hours. Therefore, the T₅₀(@1,000 nit) is estimated to be 24,300 hours. The EL performance data are summarized in Table 33. The lifetime testing curves of initial luminance vs. operational time and initial drive voltage vs. operational time are shown in FIGS 2 and 3, respectively.

### Example 13 (Inventive)

Another OLED, in accordance with the present invention, was constructed as the same as that in Example 12, except that layer e was changed as:
e) an EIL, 2.5 nm thick, including MC-20.

This OLED requires a drive voltage of about 3.5 V to pass 20 mA/cm². Under this test condition, the device has a luminance of 4,603 cd/m², and a luminous efficiency of about 23.0 cd/A. The color coordinates are CIEₓ = 0.234 and CIE_{y} = 0.627, and the emission peak is at 504 nm. Its T₅₀(@5,000 nit) is 2,174 hours. Therefore, the T₅₀(@1,000 nit) is estimated to be 28,200 hours. The EL performance data are summarized in Table 12. The lifetime testing curves of initial luminance vs. operational time and initial drive voltage vs. operational time are shown in FIGS 2 and 3, respectively.

It is shown that using MC-20 as the EIL can further improve operational lifetime and reduce voltage rise over lifetime.

**Table 12. Device data for Examples 12 and 13.**

| Example (Type) (EL measured @ RT and 20 mA/cm²) | Voltage (V) | Luminance (cd/m²) | Luminous Efficiency (cd/A) | CIE x (1931) | CIE y (1931) | Emission Peak (nm) | T₅₀(@ 1,000 nit) (Hrs) |
|---|---|---|---|---|---|---|---|
| 12 (Comparative) | 3.6 | 4,451 | 22.8 | 0.233 | 0.626 | 504 | -24,300 |
| 13 (Inventive) | 3.5 | 4,603 | 23.0 | 0.234 | 0.627 | 504 | ~28,200 |

The entire contents of the patents and other publications referred to in this specification are incorporated herein by reference.

### PARTS LIST

- 101: Substrate
- 103: Anode
- 105: Hole-Injecting layer (HIL)
- 107: Hole-Transporting Layer (HTL)
- 109: Light-Emitting layer (LEL)
- 111: Electron-Transporting layer (ETL)
- 112: Electron-Injecting layer (EIL)
- 113: Cathode
- 150: Power Source
- 160: Conductor

## Claims

1. An OLED device comprising a cathode, a light emitting layer and an anode, in that order, and, **characterized in** having located between the cathode and the light emitting layer, a further layer containing a cyclometallated complex represented by:

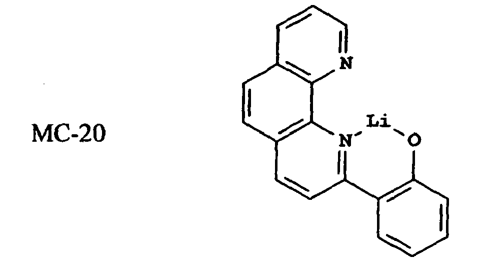

2. A device according to claim 1 wherein the light-emitting layer comprises up to 10-volume % of a light emitting compound and at least one anthracene host compound of Formula (1): 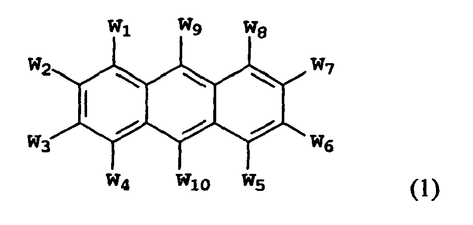 wherein
W₁-W₁₀ independently represents hydrogen or an independently selected substituent.

3. A device according to claim 2 wherein W₁-W₁₀ are independently selected from hydrogen, alkyl, aromatic carbocyclic and aromatic heterocyclic groups.

4. A device according to claim 2 wherein the anthracene compound in the light-emitting layer is selected from: 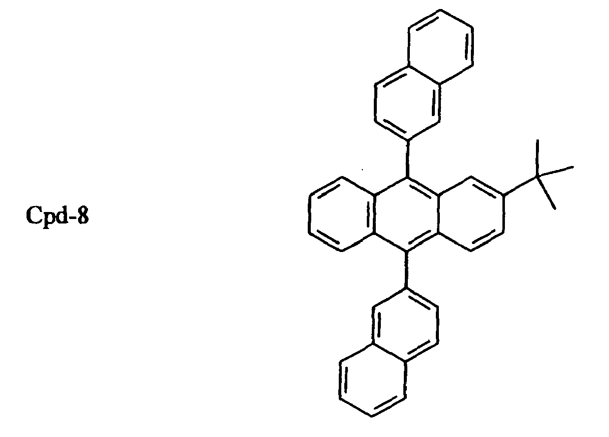 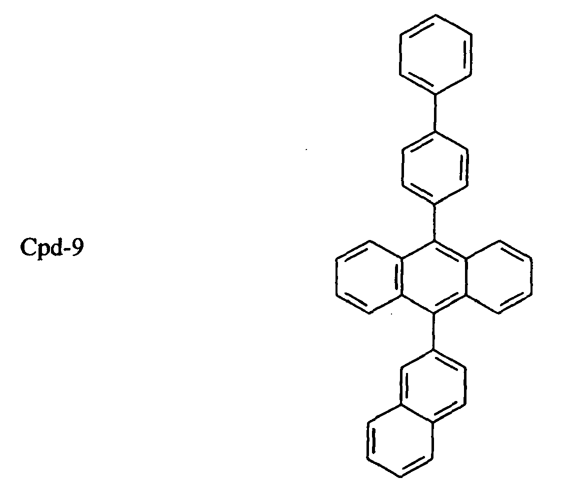 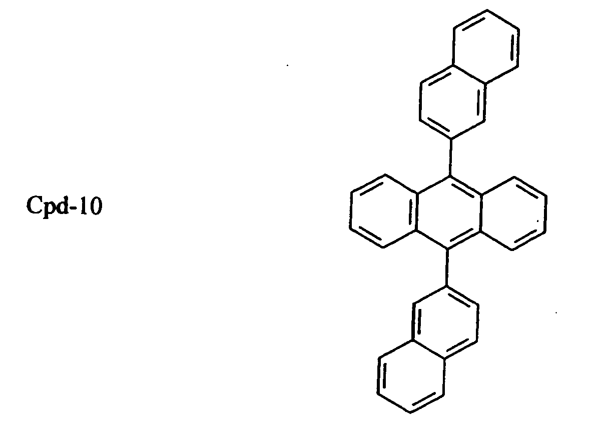 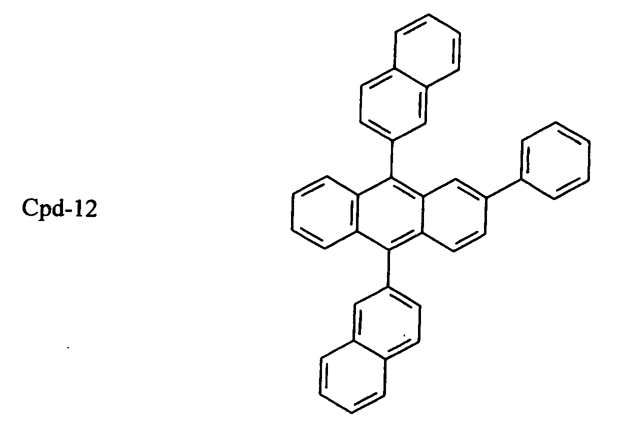 and

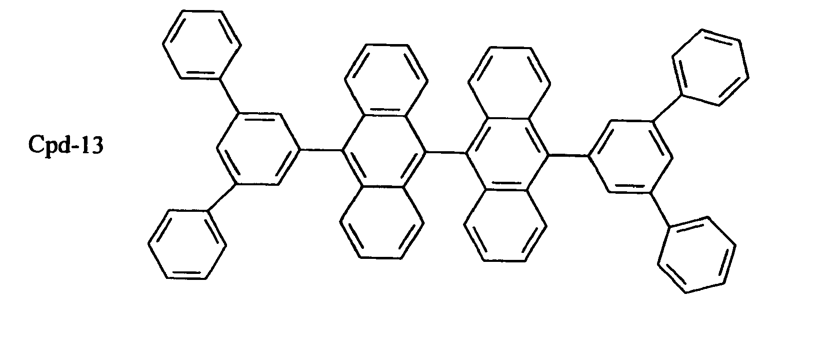

5. A device according to claim 1 wherein the further layer is adjacent to the light-emitting layer.

6. A OLED device according to claim 1 or 2 comprising an additional layer, located between the anode and the light emitting layer, containing a compound of Formula (2) 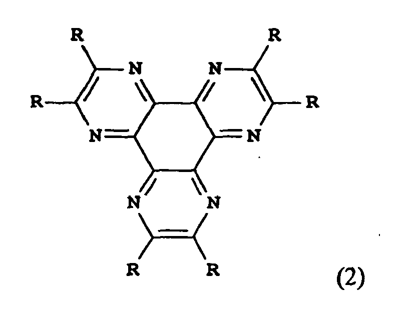 wherein:
R independently represents hydrogen or an independently selected substituent, at least one R representing an electron-withdrawing substituent having a Hammett's sigma para value of at least 0.3.

7. A device according to claim 6 wherein each R group is independently selected from the group consisting of nitrile, nitro, ester, and amide, groups.

8. A device according to claim 6 wherein the compound of Formula (2) is selected from:

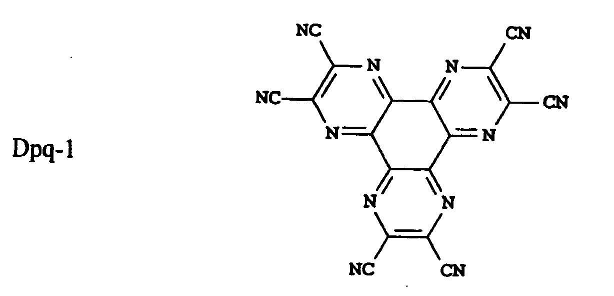

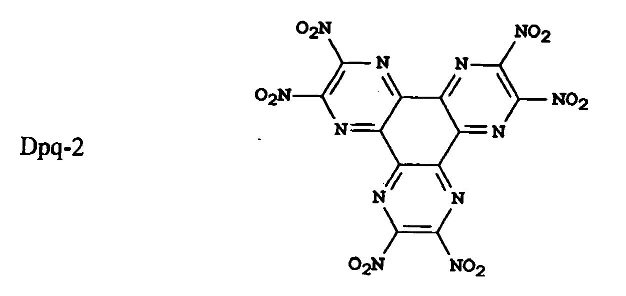

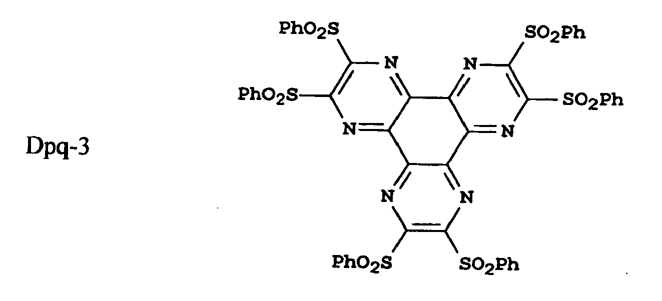

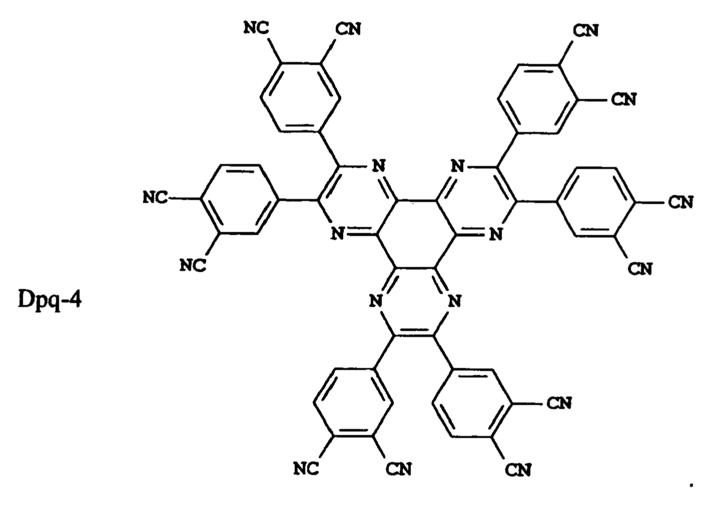

## Patentansprüche

1. OLED-Vorrichtung, umfassend eine Kathode, eine Licht emittierende Schicht und eine Anode in dieser Reihenfolge und **dadurch gekennzeichnet, dass** zwischen der Kathode und der Licht emittierenden Schicht eine weitere Schicht angeordnet ist, die einen cyclometallierten Komplex enthält, der dargestellt wird durch:

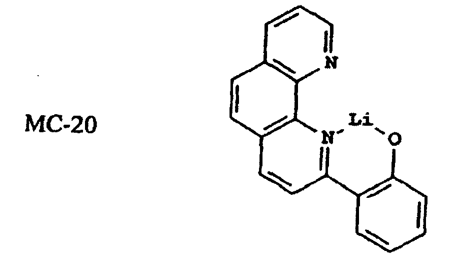

2. Vorrichtung nach Anspruch 1, bei der die Licht emittierende Schicht bis zu 10 Volumen-% einer Licht emittierenden Verbindung und mindestens eine Anthracen-Wirtsverbindung der Formel (1) umfasst: 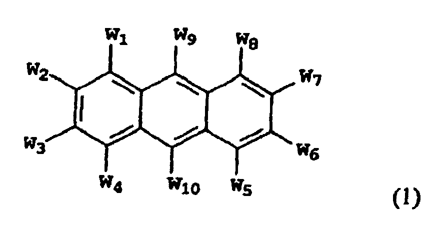 in der
W₁ - W₁₀ unabhängig Wasserstoff oder einen unabhängig ausgewählten Substituenten darstellen.

3. Vorrichtung nach Anspruch 2, bei der W₁ - W₁₀ unabhängig aus Wasserstoff, Alkyl, aromatischen carbocyclischen und aromatischen heterocyclischen Gruppen ausgewählt sind.

4. Vorrichtung nach Anspruch 2, bei der die Anthracen-Verbindung in der Licht emittierenden Schicht ausgewählt ist aus: 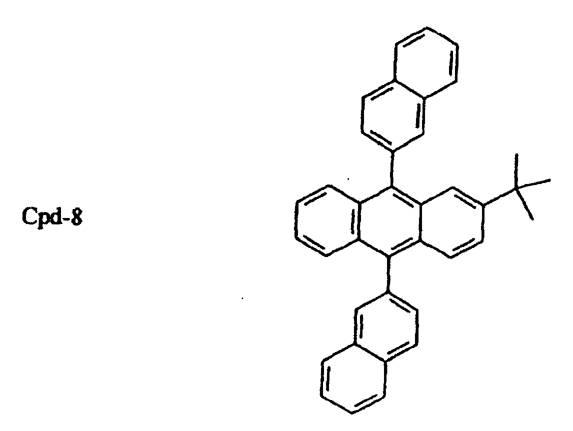 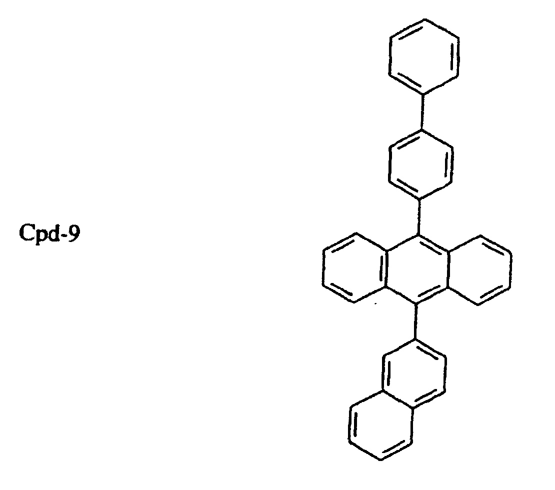 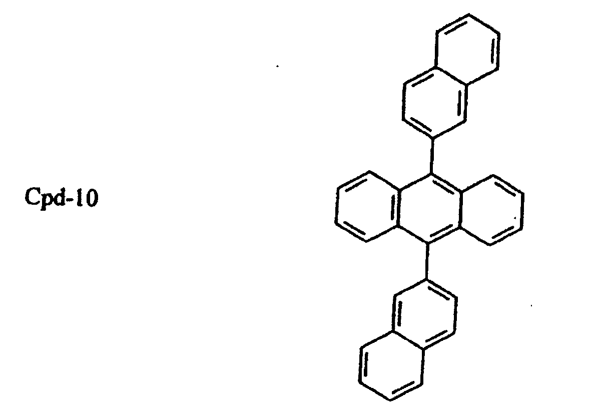 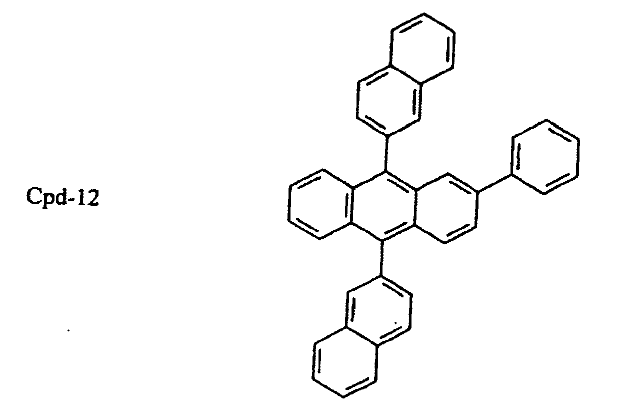 und

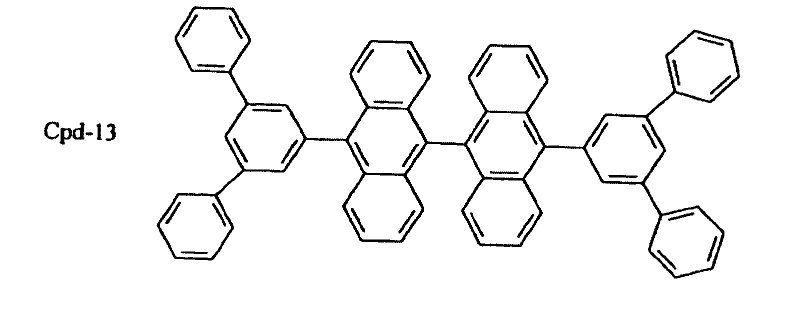

5. Vorrichtung nach Anspruch 1, bei der die weitere Schicht an die Licht emittierende Schicht angrenzt.

6. OLED-Vorrichtung nach Anspruch 1 oder 2, umfassend eine zusätzliche Schicht, die zwischen der Anode und der Licht emittierenden Schicht angeordnet ist und eine Verbindung der Formel (2) enthält: 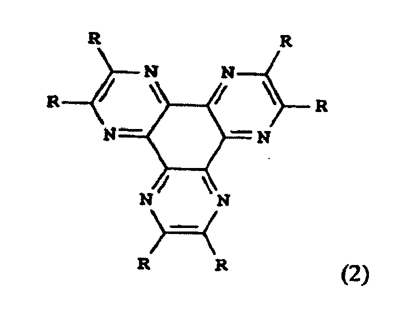 in der:
R unabhängig Wasserstoff oder einen unabhängig ausgewählten Substituenten darstellt, wobei mindestens ein R einen Elektronen abziehenden Substituenten mit einem Hammet-sigma-para-Wert von mindestens 0,3 darstellt.

7. Vorrichtung nach Anspruch 6, bei der jede Gruppe R unabhängig ausgewählt ist aus der Gruppe bestehend aus Nitril-, Nitro-, Ester- und Amid-Gruppen.

8. Vorrichtung nach Anspruch 6, bei der die Verbindung der Formel (2) ausgewählt ist aus:

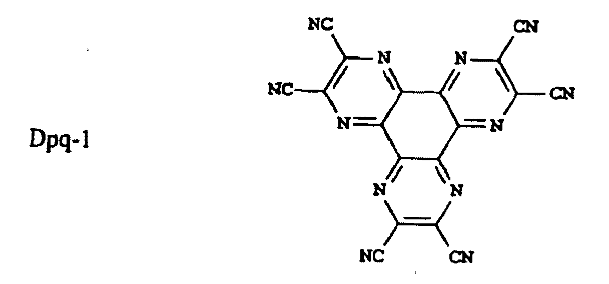

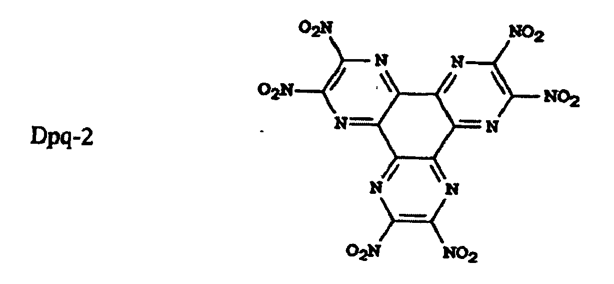

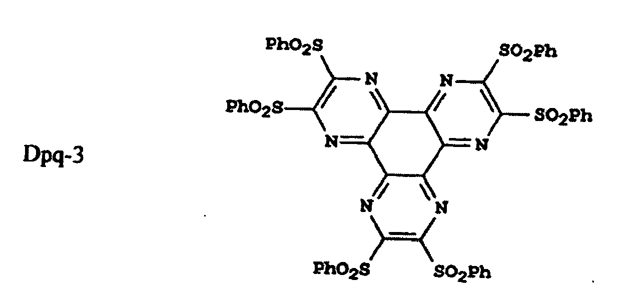

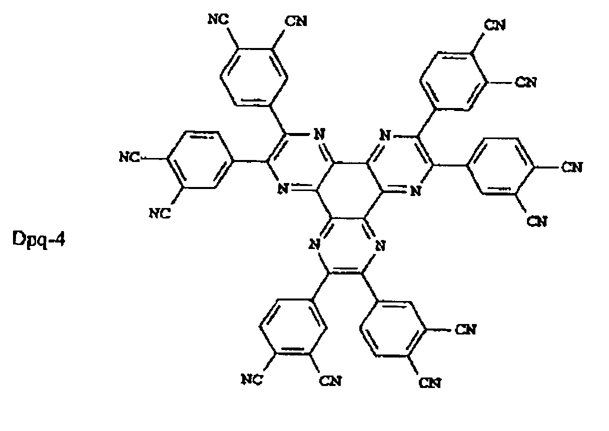

## Revendications

1. Dispositif OLED comprenant une cathode, une couche émettrice de lumière et une anode, dans cet ordre, et **caractérisé en ce qu'**ayant, située entre la cathode et la couche émettrice de lumière, une autre couche contenant un complexe cyclométallisé représenté par :

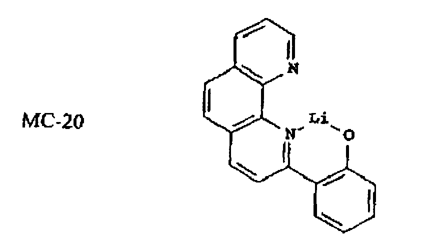

2. Dispositif selon la revendication 1, dans lequel la couche émettrice de lumière comprend jusqu'à 10 % en volume d'un composé émetteur de lumière et au moins un composé hôte anthracène de formule (1) : 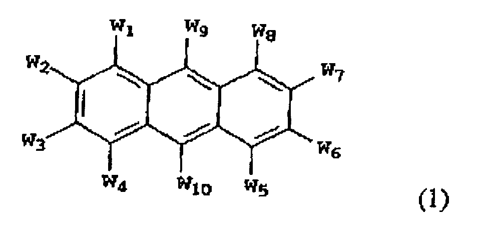 dans lequel
W₁ à W₁₀ représentent indépendamment un hydrogène ou un substituant choisi indépendamment.

3. Dispositif selon la revendication 2, dans lequel W₁ à W₁₀ sont choisis indépendamment parmi un hydrogène, des groupes alkyle, carbocycliques aromatiques et hétérocycliques aromatiques.

4. Dispositif selon la revendication 2, dans lequel le composé anthracène dans la couche émettrice de lumière est choisi parmi : 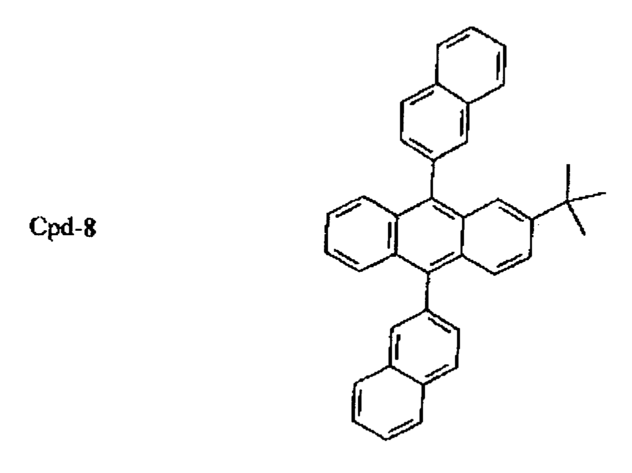 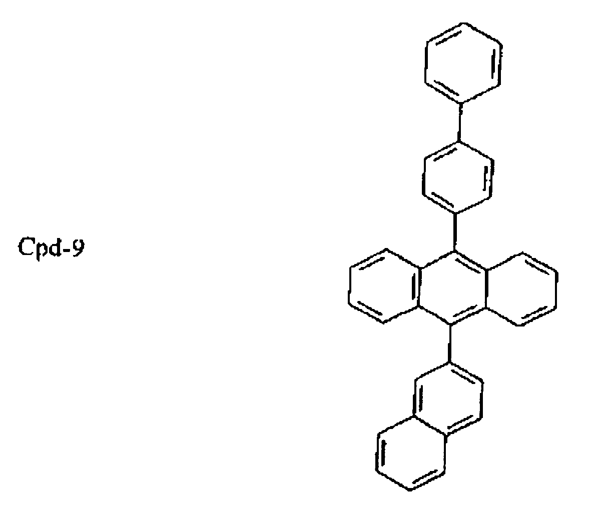 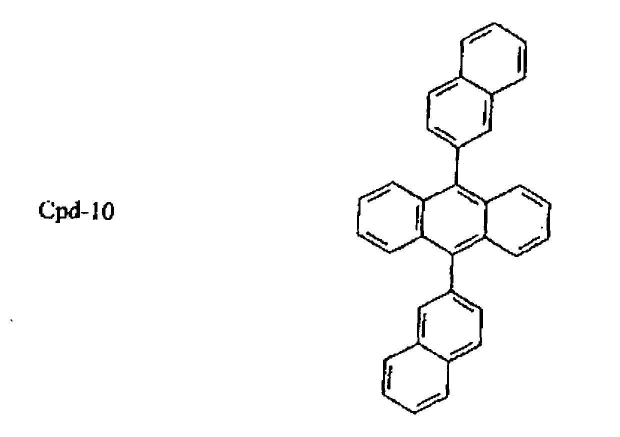 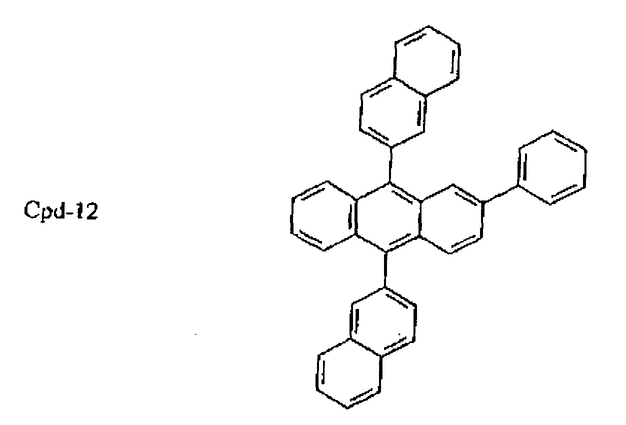 et

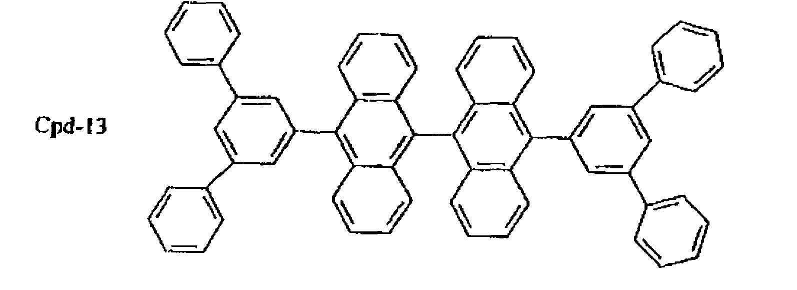

5. Dispositif selon la revendication 1, dans lequel l'autre couche est adjacente à la couche émettrice de lumière.

6. Dispositif OLED selon la revendication 1 ou 2 comprenant une couche additionnelle, située entre l'anode et la couche émettrice de lumière, contenant un composé de formule (2) 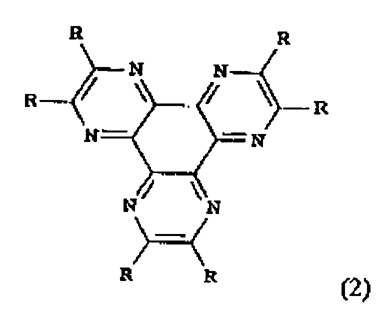 dans lequel :
R représente indépendamment un hydrogène ou un substituant choisi indépendamment, au moins un R représentant un substituant de retrait d'électron ayant une valeur de paramètre sigma de Hammett d'au moins 0,3.

7. Dispositif selon la revendication 6, dans lequel chaque groupe R est indépendamment choisi parmi le groupe consistant en des groupes nitrile, nitro, ester et amide.

8. Dispositif selon la revendication 6, dans lequel le composé de formule (2) est choisi parmi :
